# EUROPEAN PATENT APPLICATION

(11) **EP 2 367 208 A2**
(43) Date of publication of application: **21.09.2011**
(21) Application number: 11250317.2
(22) Date of filing: 16.03.2011
(51) Int. Cl.: H01L 31/032, H01L 31/0336

(54) **Thin-film solar battery and method for producing the same**

(30) Priority: 17.03.2010 JP 2010061570; 17.03.2010 JP 2010061572; 10.03.2011 JP 2011053113
(71) Applicant: Ricoh Company, Ltd, Ohta-ku Tokyo 143-8555 (JP)
(72) Inventor: Deguchim Hiroshi, Tokxo (JP); Miura, Hiroshi, Ohata-ku Tokyo (JP); Tsuiji, Kazuaki, Ohta-ku, Tokyo (JP); Yuzurihara, Hajime, Ohta-ku Tokyo (JP)
(74) Representative: Lamb, Martin John Carstairs

(57) **Abstract**

To provide a thin-film solar battery including a substrate, a first electrode, a photoelectric conversion layer and a second electrode, the first electrode, the photoelectric conversion layer and the second electrode being placed over the substrate, wherein the photoelectric conversion layer has a laminated layer structure which includes at least a p-type layer and an n-type layer, and wherein the n-type layer is formed of a compound containing elements of Group 13, Group 16 and at least one of Groups 2, 7 and 12, the Group 13 includes at least indium, and the Group 16 includes at least sulfur.

## Description

### BACKGROUND OF THE INVENTION

### Field of the Invention

The present invention relates to a thin-film solar battery using a compound material, and a method for producing a thin-film solar battery, The term "solar battery" as used herein also covers a solar cell.

### Description of the Related Art

As photoelectric conversion layers (light-absorbing layers) of thin-film solar batteries, those including compound semiconductor films are known. Known materials for such compound semiconductor films include chalcopyrite compounds (for example, CuInSe₂, CuInS₂ and CuGaInSe₂) referred to as "CIS-based compounds and CIGS-based compounds". Any of these materials can be used as a p-type photoelectric conversion layer where electron holes (holes), generated by absorption of light, move. As for the structure of a thin-film solar battery using such a p-type photoelectric conversion layer, a laminated layer structure which includes a first electrode, a p-type photoelectric conversion layer, a buffer layer, a window layer (formed of an n-type semiconductor film) and a second electrode (transparent electrode) is widely known.

In a thin-film solar battery with the above-mentioned laminated layer structure, photoelectric conversion is performed by moving electron holes, generated by a p-type photoelectric conversion layer's absorption of light that has passed through a window layer (n-type semiconductor film) and entered, as carriers. Also, a buffer layer, which is a very thin compound semiconductor film, is provided between the p-type photoelectric conversion layer and the window layer (n-type semiconductor film). This buffer layer has the function of enhancing energy efficiency for the whole of the solar battery by reducing defects at the interface between the p-type photoelectric conversion layer and the window layer (n-type semiconductor film) and thus suppressing recombination of carriers, and this buffer layer does not perform photoelectric conversion.

As methods for producing compound semiconductor films that are components of the thin-film solar battery, the following methods are widely used: for the p-type photoelectric conversion layer, a method involving vacuum vapor deposition and a method of performing heat treatment in a selenium-containing atmosphere (selenization method or precursor method); for the buffer layer, a solution-growth method (CBD method, i.e., chemical bath deposition method) in which film formation is performed by using a solution and utilizing a chemical reaction.

In such a thin-film solar battery, it is important to enhance the energy efficiency of the photoelectric conversion layer itself. Generally, it is known that high-temperature treatment of the material for the p-type photoelectric conversion layer improves a crystalline state and thus improves a photoelectric conversion property.

For example, Japanese Patent Application Laid-Open (JP-A) No. 2003-8039 proposes a thin-film solar battery with a laminated layer structure, in which a CIS-based compound film is used as a p-type photoelectric conversion layer, a ZnIn-based compound semiconductor film containing Zn-In-Se or Zn-In-S (for example, a film of ZnIn₂Se₄) is used as a buffer layer, and ZnO is used for a window layer (n-type semiconductor layer). In a production process of the thin-film solar battery with the laminated layer structure, if mutual diffusion of the components arises between the CIS-based compound film (as the p-type photoelectric conversion layer) and the buffer layer, the energy efficiency of the solar battery decreases, and so suppression of the mutual diffusion between the p-type photoelectric conversion layer and the buffer layer is demanded. Accordingly, in this thin-film solar battery, a ZnIn-based compound semiconductor film that does not easily cause mutual diffusion with the CIS-based compound film is used as the buffer layer. As a production method of the CIS-based compound film and the ZnIn-based compound semiconductor film, a selenization method which involves heat treatment at a high temperature of 400°C to 500°C in a selenium-containing atmosphere is used to improve a crystalline state, improve a photoelectric conversion property of the p-type photoelectric conversion layer and thus enhance energy efficiency.

Meanwhile, International Publication No. WO2005/064692 describes a thin-film solar battery with the above-mentioned laminated layer structure, wherein a ZnIn-based compound semiconductor film, such as of ZnIn(O, OH, S), for use as a buffer layer is produced by a CBD method.

It is important that thin-film solar batteries enable reduction in production costs as well as yielding high energy efficiency. To reduce production costs, increase in throughput using a simple production method is desirable. However, regarding the thin-film solar battery of JP-A No. 2003-8039, a selenization method which involves high-temperature treatment (400°C to 500°C) is used for the formation of a p-type photoelectric conversion layer and a buffer layer in order to enhance energy efficiency. The selenization method involving such high-temperature treatment requires a lot of time in increasing and lowering the temperature and therefore makes it difficult to secure high throughput. Regarding the thin-film solar battery described in International Publication No. WO2005/064692, a production method using a CBD method in order to provide a buffer layer is described. However, the CBD method requires a long period of time for a chemical reaction using a solution and therefore makes it difficult to secure high throughput.

Recently, it has been found that a layer of CdTe as a p-type photoelectric conversion layer can be produced by a close-spaced sublimation method (a kind of vacuum film formation) with higher throughput than by conventional methods such as vacuum vapor deposition and a selenization method, and the close-spaced sublimation method has been put to practical use. However, the close-spaced sublimation method involves high-temperature treatment with a heat treatment temperature of approximately 600°C and is therefore not satisfactory in terms of increase in throughput.

Also, to gain high energy efficiency, it is preferred that an n-type semiconductor layer, as well as a p-type photoelectric conversion layer, generate carriers by light irradiation, in other words have a photocurrent (photoconductive) property.

### BRIEF SUMMARY OF THE INVENTION

The present invention is aimed at providing a thin-film solar battery using a compound semiconductor film, which secures a favorable balance between high throughput and generation of carriers in an n-type semiconductor layer to realize high energy efficiency; and a method for producing a thin-film solar battery.

As a result of carrying out a series of earnest examinations in an attempt to solve the problems, the present inventors have found that the following thin-film solar battery exhibits a favorable photoelectric conversion property and also exhibits favorable carrier mobility: a thin-film solar battery including a substrate, and also including, over the substrate, a first electrode, a photoelectric conversion layer and a second electrode, wherein the photoelectric conversion layer has a laminated layer structure which includes at least a p-type layer and an n-type layer, and wherein the n-type layer is formed of a compound containing elements of Group 13, Group 16 and at least one of Groups 2, 7 and 12, the Group 13 includes at least indium (In), and the Group 16 includes at least sulfur (S) (hereinafter, the compound will be referred to also as "II-III(In)-VI(S)").

Here, the sign "II" denotes at least one group selected from Groups 2, 7 and 12. The sign "III(In)" denotes Group 13 and inclusion of at least indium. The sign "VI(S)" denotes Group 16 and inclusion of at least sulfur.

The present inventors have also found that a II-III(In)-VI(S) compound thin film produced at a low temperature (300°C or lower) exhibits a photoelectric conversion property and carrier mobility which are as favorable as or more favorable than those of a II-III(In)-VI(S) compound thin film produced at a high temperature (400°C to 500°C). This means that even if a II-III(In)-VI(S) compound thin film is produced at a low temperature, it can be used as an n-type photoelectric conversion layer that exhibits favorable energy efficiency.

The present invention is based upon the above-mentioned findings of the present inventors, and means for solving the problems are as follows.
<1> A thin-film solar battery including: a substrate; a first electrode; a photoelectric conversion layer; and a second electrode, the first electrode, the photoelectric conversion layer and the second electrode being placed over the substrate, wherein the photoelectric conversion layer has a laminated layer structure which includes at least a p-type layer and an n-type layer, and wherein the n-type layer is formed of a compound containing elements of Group 13, Group 16 and at least one of Groups 2, 7 and 12, the Group 13 includes at least indium, and the Group 16 includes at least sulfur.
<2> The thin-film solar battery according to <1>, wherein the at least one of the Groups 2, 7 and 12 includes at least one element selected from magnesium, calcium, strontium, barium, zinc, cadmium and manganese, the Group 13 includes indium and at least one element selected from gallium, aluminum and boron, and the Group 16 includes sulfur and at least one element selected from tellurium, selenium and oxygen.
<3> The thin-film solar battery according to <1> or <2>, wherein the n-type layer contains zinc, indium and sulfur.
<4> The thin-film solar battery according to <1> or <2>, wherein the n-type layer contains zinc, strontium, indium and sulfur.
<5> The thin-film solar battery according to <1> or <2>, wherein the n-type layer contains zinc, indium, sulfur and oxygen.
<6> The thin-film solar battery according to any one of <1> to <5>, wherein the n-type layer is in an amorphous state as a structural state.
<7> A method for producing a thin-film solar battery, including: producing the thin-film solar battery according to any one of <1> to <6>, wherein the n-type layer is formed by sputtering.

In a thin-film solar battery of the present invention, by forming a photoelectric conversion layer so as to have a laminated layer structure which includes at least a p-type layer, and an n-type layer which is formed of a II-III(In)-VI(S) compound thin film, it is possible to make higher the energy efficiency of the photoelectric conversion layer itself than in a conventional structure wherein a photoelectric conversion layer is formed only of a p-type layer. For a conventional photoelectric conversion layer formed only of a p-type layer, a means of improving a crystalline state by producing the p-type layer at a high temperature (400°C to 500°C) has been used to enhance the energy efficiency of the photoelectric conversion layer itself. Meanwhile, in the present invention, by forming a photoelectric conversion layer in which at least a p-type layer and an n-type layer are laid one on top of the other, it is possible to enhance the energy efficiency of the photoelectric conversion layer itself, without necessitating high-temperature production.

Also, regarding a conventional thin-film solar battery using a photoelectric conversion layer formed only of a p-type layer, the energy efficiency of the whole of the solar battery is enhanced by providing a buffer layer, which does not perform photoelectric conversion, between the photoelectric conversion layer and a transparent conductive layer (n-type semiconductor film), thus reducing defects at the interface and suppressing recombination of carriers. Meanwhile, the structure of the thin-film solar battery of the present invention is a laminated layer structure including a first electrode, a photoelectric conversion layer formed by laying at least a p-type layer and an n-type layer one on top of the other, and a second electrode, but not including a buffer layer. Accordingly, production processes whereby high throughput can hardly be secured, such as a CBD method and a selenization method involving high-temperature treatment, conventionally used in forming buffer layers, are not required.

Thus, the thin-film solar battery of the present invention can be produced with higher throughput than conventional thin-film solar batteries because a photoelectric conversion layer with high energy efficiency, which is formed by laying at least a p-type layer and an n-type layer one on top of the other and can be produced at a low temperature, is provided between a second electrode and a first electrode.

The present invention makes it possible to solve the problems in related art and provide a thin-film solar battery using a compound semiconductor film, which secures a favorable balance between high throughput and generation of carriers in an n-type semiconductor layer to realize high energy efficiency, and a method for producing a thin-film solar battery.

### BRIEF DESCRIPTION OF THE DRAWINGS

FIG. 1 is a cross-sectional view showing an example of a layer structure of a thin-film solar battery of the present invention.
FIG. 2 is a cross-sectional view of a structure including a II-III(In)-VI(S) compound thin film, used in Examples 1, 2, 3, 4, 5, 6, 7, 8, 9, 10, 11, 12, 13 and 14.
FIG. 3 is a cross-sectional view of a structure including a II-III(In)-VI(S) compound thin film, used in Examples 15 and 16.
FIG. 4 is a graph showing a photoelectric conversion property of a ZnInS thin film as a form of resistance change caused by light irradiation (Example 4).
FIG. 5 is a graph showing the mobility of a ZnInS thin film (Example 14).
FIG. 6 is a graph showing the result of measurement of a ZnInS thin film by energy dispersive X-ray spectrometry (EDS) (Example 15).
FIG. 7 shows X-ray diffraction profiles in relation to a ZnInS thin film (Example 16).
FIG. 8 is a graph showing how the angle and the half width of an X-ray diffraction peak with a maximum intensity change according to the annealing temperature regarding a ZnInS thin film (Example 16).
FIG. 9 is a graph showing a current-voltage (I-V) characteristic as an electricity-generating property of a thin-film solar battery of Example 17.
FIG. 10 is a graph showing a current-voltage (I-V) characteristic as an electricity-generating property of a thin-film solar battery of Example 18.
FIG. 11 is a graph related to Example 19, showing changes in current-voltage (I-V) characteristic according to the annealing temperature.
FIG. 12 is a graph showing a current-voltage (I-V) characteristic as an electricity-generating property of a thin-film solar battery of Example 20.
FIG. 13 is a graph showing a current-voltage (I-V) characteristic as an electricity-generating property of a thin-film solar battery of Example 21.
FIG. 14 is a graph showing a current-voltage (I-V) characteristic as an electricity-generating property of a thin-film solar battery of Example 22.
FIG. 15 is a graph showing a current-voltage (I-V) characteristic as an electricity-generating property of a thin-film solar battery of Example 23.
FIG. 16 is a graph showing a current-voltage (I-V) characteristic as an electricity-generating property of a thin-film solar battery of Example 24.
FIG. 17 is a graph showing a current-voltage (I-V) characteristic as an electricity-generating property of a thin-film solar battery of Example 25.
FIG. 18 is a graph showing a current-voltage (I-V) characteristic as an electricity-generating property of a thin-film solar battery of Example 26.
FIG. 19 is a graph showing a current-voltage (I-V) characteristic as an electricity-generating property of a thin-film solar battery of Example 27.
FIG. 20 is a graph showing a current-voltage (I-V) characteristic as an electricity-generating property of a thin-film solar battery of Comparative Example 1.
FIG. 21 is a graph showing a current-voltage (I-V) characteristic as an electricity-generating property of a thin-film solar battery of Comparative Example 2.
FIG. 22 is a graph showing a current-voltage (I-V) characteristic as an electricity-generating property of a thin-film solar battery of Comparative Example 3.

### DETAILED DESCRIPTION OF THE INVENTION

### (Thin-film Solar Battery and Method for Producing Thin-film Solar Battery)

A thin-film solar battery of the present invention includes a substrate, also includes, over the substrate, a first electrode, a photoelectric conversion layer and a second electrode, and may, if necessary, include other members.

A method of the present invention for producing a thin-film solar battery is a method for producing the above-mentioned thin-film solar battery of the present invention, wherein an n-type layer is formed by sputtering.

The following specifically explains the present invention's thin-film solar battery and method for producing a thin-film solar battery.

The photoelectric conversion layer has a laminated layer structure which includes at least a p-type layer and an n-type layer.

The n-type layer is formed of a compound containing elements of Group 13, Group 16 and at least one of Groups 2, 7 and 12, the Group 13 includes at least indium, and the Group 16 includes at least sulfur.

Regarding the n-type layer, it is preferred that the above-mentioned at least one of the Groups 2, 7 and 12 include at least one element selected from magnesium, calcium, strontium, barium, zinc, cadmium and manganese, that the Group 13 include indium and at least one element selected from gallium, aluminum and boron, and that the Group 16 include sulfur and at least one element selected from tellurium, selenium and oxygen, in view of the fact that band gap adjustment can be favorably performed, photocurrent properties can be improved, coordination of the n-type layer and the p-type layer is possible, etc.

It is preferred that the n-type layer contain zinc, indium and sulfur in view of photocurrent properties.

It is preferred that the n-type layer contain zinc, strontium, indium and sulfur in view of photocurrent properties and increase in open-circuit voltage (Voc) owing to enlargement of the band gap.

It is preferred that the n-type layer contain zinc, indium, sulfur and oxygen in view of photocurrent properties and increase in open-circuit voltage (Voc) owing to enlargement of the band gap.

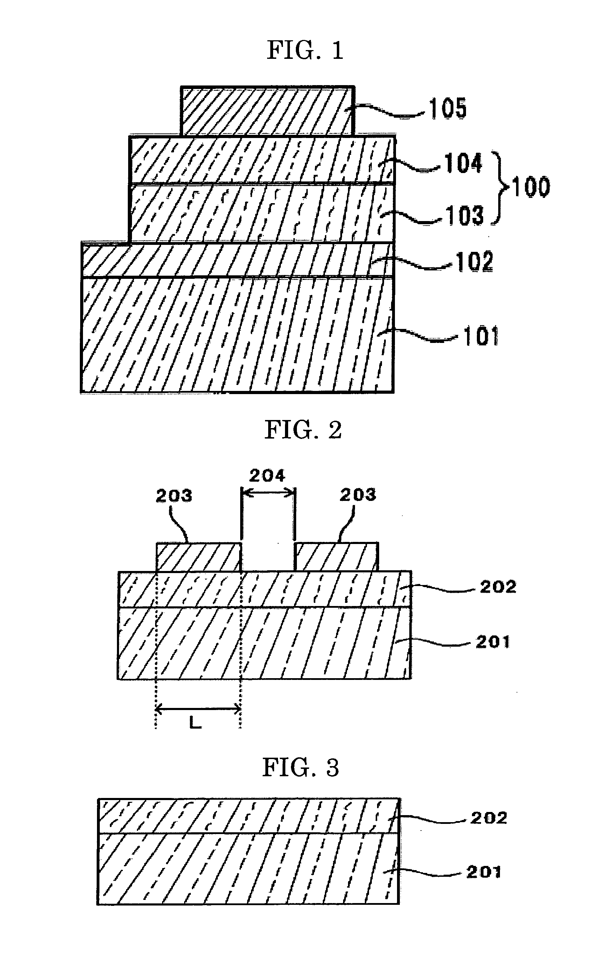

Here, the thin-film solar battery of the present invention will be specifically explained referring to drawings. FIG. 1 is a cross-sectional view showing an example of a layer structure of a thin-film solar battery to which the present invention is applied. The thin-film solar battery in FIG. 1 has a layer structure in which a first electrode 102, a photoelectric conversion layer 100 formed by laying a p-type layer 103 and an n-type layer 104 one on top of the other, and a second electrode 105 are laid over a support substrate 101.

### - Support Substrate -

The support substrate 101 is not particularly limited and may be suitably selected according to the intended purpose; for example, it may be a glass substrate, a quartz substrate or a plastic substrate. The side of the surface of the support substrate 101 where the layers are formed may be provided with a concavo-convex structure. With the concavo-convex structure, there is an increase in light-absorbing efficiency due to a light-confining effect yielded by light scattering. Examples of materials usable for the plastic substrate include polycarbonates.

The thickness of the support substrate is preferably in the range of 50 µm to 10 mm.

### - First Electrode -

For the first electrode 102, a metal material such as aluminum (Al), silver (Ag), gold (Au), platinum (Pt) or molybdenum (Mo) can be used. The most suitable material for the first electrode 102 should be selected in view of the material for the photoelectric conversion layer 100, such that an ohmic contact is secured. Also, the first electrode 102 is required to have favorable adhesion to the support substrate 101.

As a method for forming the first electrode 102, vacuum vapor deposition, sputtering, etc. can be used.

The thickness of the first electrode 102 is preferably 200 nm or greater and is determined in view of such conditions as sufficiently low resistivity and high adhesion.

The photoelectric conversion layer 100 has a laminated layer structure which includes the p-type layer 103 and the n-type layer 104.

For the p-type layer 103, anything among selenium compound materials and sulfide materials, such as CuInSe₂, CuInS₂ and CuGaInSe₂ that are chalcopyrite compounds as mentioned in Description of the Related Art, can be used. As a method for forming the p-type layer 103, vacuum vapor deposition, sputtering, etc. can be used. Note that heat treatment in a selenium atmosphere or a sulfur atmosphere may, for example, be carried out as in a selenization method or a sulfurization method.

The thickness of the p-type layer 103 is preferably in the range of 10 nm to 2 µm, more preferably 100 nm to 1 µm. When the thickness of the p-type layer 103 is greater than 2 µm, there may be a decrease in productivity and thus an increase in costs.

The thickness of the p-type layer can be measured, for example by using an optical method (with a spectroscopic thickness meter that utilizes light interference or ellipsometry) or by using a mechanical method (with a palpation meter or an atomic force microscope (AFM)).

For the p-type layer 103, a tellurium compound such as AgInTe₂, AgGaTe₂ or CdTe can also be used.

As the n-type layer 104, a II-III(In)-VI(S) compound thin film is used. Here, the sign II preferably denotes at least one element selected from Mg, Ca, Sr and Ba (which are Group 2 elements), Zn and Cd (which are Group 12 elements) and Mn (which is a Group 7 element). Also, in view of the band gap (Eg) required for the photoelectric conversion layer 100, the band gap thereof is preferably 1.0 eV or greater, but less than 3 eV, more preferably in the vicinity of 2 eV. If application thereof to a top cell of a multi-junction solar battery (on the light entrance side) is conceived, it is not necessary to adjust the band gap to the range (Eg = 1 eV to 1.4 eV) generally deemed suitable for a single-junction thin-film solar battery, and a wider band gap (Eg) range is preferable. Meanwhile, the relationship Eg < 1 eV is required for a bottom cell of the multi-junction solar battery. Among the above-mentioned elements, Zn is particularly preferred in view of structural stability and environmental suitability. A two-element mixture composed of Zn and Sr is even more preferred. Examples of compounds whose band gaps (Eg) are in the range of 2 eV to 2.5 eV include ZnIn₂S₄ and CdIn₂S₄.

For adjustment of the Eg, it is possible to employ a method of using any of In, Ga, Al and B (which are Group 13 elements) alone or in combination, or using any of S, Se and O (which are Group 16 elements) alone or in combination. It should, however, be noted that in the case of use of any of Ga, Al and B (which are Group 13 elements) alone or in combination or use of O (which is a Group 16 element), for example, the Eg becomes too large. Accordingly, at least indium needs to be included in the elements constituting the above-mentioned Group 13 and at least sulfur needs to be included in the elements constituting the above-mentioned Group 16.

The above-mentioned Eg of the n-type layer is effective in selecting the wavelength of incident light as described above and is also effective in optimizing the open-circuit voltage (Voc) derived from the difference between the Eg of the n-type layer and the Eg of the p-type layer.

As a method for forming the n-type layer, it is possible to use, for example, vacuum vapor deposition, sputtering, a precursor method, or an application method in which a material is made into ink and then applied so as to form a film.

In the photoelectric conversion layer 100 of the thin-film solar battery of the present embodiment, mainly the n-type layer 104 generates photocarriers, and so the thickness of the II-III(In)-VI(S) compound thin film serving as the n-type layer is preferably in the range of 200 nm to 2 µm, more preferably 200 nm to 1 µm. The thickness of the n-type layer can be measured, for example by using an optical method (with a spectroscopic thickness meter that utilizes light interference or ellipsometry) or by using a mechanical method (with a palpation meter or an atomic force microscope (AFM)).

Note that if photocarriers generated by the p-type layer 103 are utilized as well, optimization of the thickness thereof is required.

In the thin-film solar battery described in JP-A No. 2003-8039, a buffer layer, formed of a very thin ZnInS film that is less than 100 nm in thickness, is provided between a photoelectric conversion layer and a translucent material layer. For this buffer layer, a high-resistance n-type semiconductor is used to reduce defects at the interface between the photoelectric conversion layer and the translucent material layer and prevent recombination of carriers. The buffer layer itself hardly contributes to generation of electricity, and the buffer layer performs the above-mentioned functions if it is thin. Meanwhile, the II-III(In)-VI(S) compound thin film in the present invention is used as the n-type layer 104 of the photoelectric conversion layer 100, and thus the thin film needs to be made thick to such an extent that the thickness thereof is in the above-mentioned thickness range, for the purpose of sufficiently absorbing light. As just described, although the II-III(In)-VI(S) compound thin film in the present invention is formed of elements that are similar to those for a conventional buffer layer, the II-III(In)-VI(S) compound thin film has very different functions.

The compositional ratio of the II-III(In)-VI(S) compound thin film as the n-type layer 104 is important in obtaining a photoelectric conversion property. In the case of vacuum vapor deposition, materials of a vapor deposition source are mixed together with an intended compositional ratio, whereas, in the case of sputtering, materials of a sputtering target are mixed together with an intended compositional ratio; then film forming conditions are adjusted, and finally a II-III(In)-VI(S) compound thin film has an intended compositional ratio. By changing the compositional ratio, the carrier density and the characteristic of mobility change. For instance, the stoichiometric compositional ratio of Zn-In-S is as follows: Zn:In:S=1:2:4; however, a compositional ratio which deviates from the stoichiometric compositional ratio is preferable in terms of a solar battery property. Crystals having the foregoing stoichiometric compositional ratio are classified as the defect chalcopyrite type and are therefore different materials from the chalcopyrite type that includes CuInSe₂ and CuInS₂. As for a production method, the compositional ratio of a vapor deposition source or sputtering target (starting materials) is set as follows: Zn:In:S=1:2:4 or so in molar ratio; in other words, the ratio of Zn to S (Zn/S) is set at 0.25 with indium being a balancing element; using starting materials with the ratio Zn/S being approximately 0.25, the ratio Zn/S is preferably adjusted to the range of 0.2 to 0.3 by adjustment of film forming conditions.

Additionally, ZnInS is a ternary compound, and it can be in a mixed state of binary compounds depending upon the production method and the production conditions employed. For example, phase separation of binary compounds such as In₂S₃ and ZnS may occur depending upon the production method and the production conditions employed. With such phase separation of binary compounds, the resistance value will deviate from a value range appropriate for the photoelectric conversion layer materials. Therefore, to suppress phase separation of binary compounds and secure a resistance value appropriate for the photoelectric conversion layer materials, it is preferred that the compositional ratio of the ZnInS thin film, represented by Zn/S, be in the above-mentioned range of 0.2 to 0.3. In the case of other II-III(In)-VI(S) compound thin film as well, the foregoing ratio is preferably in the range of 0.2 to 0.3.

In the case of any II-III(In)-VI(S) compound thin film other than a ZnInS thin film as well, it is necessary to optimize the composition for each film forming method to obtain desired solar battery properties, since the carrier concentration, the mobility, the photocurrent (photoconductive) properties, the Eg, etc. vary depending upon the compositional ratio of the thin film.

The crystalline state of the II-III(In)-VI(S) compound thin film serving as the n-type layer is preferably an amorphous state or a state of fine crystals. Here, the amorphous state refers to a state where the half width of a diffraction peak in measurement of X-ray diffraction is greater than 3°, and the half width of a diffraction peak is greater than 3° even when a thin film that is an aggregate of very small crystal grains is subjected to measurement of X-ray diffraction. The II-III(In)-VI(S) compound thin film may be an aggregate of very small crystal grains. For example, as described above, a ZnInS thin film could experience phase separation of In₂S₃ and ZnS depending upon the production method employed. The existence or absence of such phase separation and the extent of such phase separation can be grasped by measurement of X-ray diffraction. An amorphous state or a state where the half width of a diffraction peak is greater than 3° also shows that there is no noticeable phase separation of In₂S₃ or ZnS. The foregoing will be specifically explained based upon a measurement result of X-ray diffraction concerning a ZnInS thin film alone in Example 7 below.

### - Second Electrode -

For the second electrode 105 positioned on the side of entrance of sunlight, a transparent conductive film formed, for example, of ITO (In₂O₃-SnO₂), tin oxide (SnO₂), or ZnO:Al (produced by adding aluminum (Al) to zinc oxide (ZnO)) can be used. As a method for forming the second electrode 105, vacuum vapor deposition, sputtering, etc. can be used.

The thickness of the second electrode 105 is preferably in the range of 50 nm to 200 nm.

All of the first electrode 102, the p-type layer 103, the n-type layer 104 and the second electrode 105, shown in FIG. 1, are preferably formed by sputtering. As a sputtering target, a compound (alloy) target containing constituent elements in a state of a compound is used. Alternatively, an intended compound may be produced by simultaneous film formation (co-sputtering) with a plurality of metal targets containing constituent elements.

### ― Other Members ―

The above-mentioned other members are not particularly limited and may be suitably selected according to the intended purpose, and examples thereof include a gas barrier layer, a protective layer and a buffer layer.

Examples of materials usable for the gas barrier layer include inorganic materials such as silicon nitride and silicon oxide.

The thin-film solar battery of the present invention is capable of securing a favorable balance between high throughput and generation of carriers in an n-type semiconductor layer to realize high energy efficiency, and the thin-film solar battery can be suitably used as any type of thin-film solar battery, e.g., an amorphous silicon solar battery, a solar battery using a compound semiconductor film, an organic thin-film solar battery or a dye-sensitized solar battery, notably as a solar battery using a compound semiconductor film.

### EXAMPLES

The following explains Examples of the present invention. It should, however, be noted that the scope of the present invention is not confined to these Examples.

Properties of II-III(In)-VI(S) compound thin films alone, which are each used as the n-type layer 104 of the thin-film solar battery shown in FIG. 1, will be explained below referring to Examples. Examples 1, 2, 3, 4, 5, 6, 7 and 8 each explain a photoelectric conversion property of a II-III(In)-VI(S) compound thin film used as the n-type layer 104. In Examples 1, 2, 3 and 4, Cd (as a Group 12 element), Mn (as a Group 7 element), Sr (as a Group 2 element) and Zn (as a Group 12 element) were respectively used. In Example 5, a mixture of Zn (as a Group 12 element) and Sr (as a Group 2 element) was used. In Example 6, a mixture of In and Ga (as Group 13 elements) was used. In Examples 7 and 8, a mixture of S and O (as Group 16 elements) and a mixture of S and Se (as Group 16 elements) were respectively used. In Example 9, a mixture of S and Te (as Group 16 elements) was used. In Example 10, Mg (as a Group 2 element) and Zn (as a Group 12 element) were used. In Example 11, Ba (as a Group 2 element) and Zn (as a Group 12 element) were used. In Example 12, B and In (as Group 13 elements) were used. In Example 13, Al and In (as Group 13 elements) were used. Examples 14, 15 and 16 each explain a property of a ZnInS thin film alone, in which Zn (as a Group 12 element) is used.

### (Example 1)

A photoelectric conversion property of a CdInS thin film alone, serving as a II-III(In)-VI(S) compound thin film (with inclusion of a cadmium element as a Group 12 element) used as the n-type layer 104 of the thin-film solar battery in FIG. 1, is now explained. FIG. 2 is a cross-sectional view of a structure used for measurement of a photoelectric conversion property. The structure was formed by laying a CdInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The CdInS thin film was formed by RF magnetron sputtering. The compositional ratio of a sputtering target was as follows: Cd:In:S=1:2:4. The film formation atmosphere employed was an argon (Ar) gas atmosphere, and the pressure was set at 0.6 Pa. The film formation temperature was set at room temperature, and the film formation was performed without heating the substrate in a forced manner. The CdInS thin film had a thickness of 500 nm. After formed, the CdInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed (hereinafter referred to also as "post-annealing temperature") was set at 300°C. On each of the CdInS thin film 202 having been subjected to as-deposition (without post-annealing) and the CdInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each CdInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 9x10⁷ Ω (before the light irradiation) to 8x10⁶ Ω (after the light irradiation). The resistance value of the thin film having been subjected to the post-annealing at 300°C changed from 5x10⁷ Ω (before the light irradiation) to 3x10⁶ Ω (after the light irradiation). In both these cases, the resistance value decreased because of generation of a photoelectric current caused by the light irradiation. This means that a CdInS thin film exhibits a photoelectric conversion property even in the case of as-deposition (without annealing) or low-temperature annealing at approximately 300°C and is therefore a material useful for forming a solar battery at a low process temperature.

### (Example 2)

A photoelectric conversion property of an MnInS thin film alone, serving as a II-III(In)-VI(S) compound thin film (with inclusion of a manganese element as a Group 7 element) used as the n-type layer 104 of the thin-film solar battery in FIG. 1, is now explained. A structure used for measurement of a photoelectric conversion property is shown in the cross-sectional view of FIG. 2, as is the structure of Example 1. Specifically, the structure was formed by laying an MnInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The MnInS thin film was formed by RF magnetron sputtering. The compositional ratio of a sputtering target was as follows: Mn:In:S=1:2:4. The film formation atmosphere employed was an argon (Ar) gas atmosphere, and the pressure was set at 0.6 Pa. The film formation temperature was set at room temperature, and the film formation was performed without heating the substrate in a forced manner. The MnInS thin film had a thickness of 500 nm. After formed, the MnInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the MnInS thin film 202 having been subjected to as-deposition (without post-annealing) and the MnInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each MnInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 3x10⁶ Ω (before the light irradiation) to 7x10⁵ Ω (after the light irradiation). The resistance value of the thin film having been subjected to the post-annealing at 300°C changed from 1x10⁶ Ω (before the light irradiation) to 7x10⁵ Ω (after the light irradiation). In both these cases, the resistance value decreased because of generation of a photoelectric current caused by the light irradiation. This means that a MnInS thin film exhibits a photoelectric conversion property even in the case of as-deposition (without annealing) or low-temperature annealing at approximately 300°C and is therefore a material useful for forming a solar battery at a low process temperature.

### (Example 3)

A photoelectric conversion property of an SrInS thin film alone, serving as a II-III(In)-VI(S) compound thin film (with inclusion of a strontium element as a Group 2 element) used as the n-type layer 104 of the thin-film solar battery in FIG. 1, is now explained. A structure used for measurement of a photoelectric conversion property is shown in the cross-sectional view of FIG. 2, as are the structures of Examples 1 and 2. Specifically, the structure was formed by laying an SrInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The SrInS thin film was formed by RF magnetron sputtering. The compositional ratio of a sputtering target was as follows: Sr:In:S=1:2:4. The film formation atmosphere employed was an argon (Ar) gas atmosphere, and the pressure was set at 0.6 Pa. The film formation temperature was set at room temperature, and the film formation was performed without heating the substrate in a forced manner. The SrInS thin film had a thickness of 500 nm. After formed, the SrInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the SrInS thin film 202 having been subjected to as-deposition (without post-annealing) and the SrInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each SrInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 3x10⁷ Ω (before the light irradiation) to 1x10⁶ Ω (after the light irradiation). The resistance value of the thin film having been subjected to the post-annealing at 300°C changed from 7x10⁶ Ω (before the light irradiation) to 8x10⁵ Ω after the light irradiation). In both these cases, the resistance value decreased because of generation of a photoelectric current caused by the light irradiation. This means that an SrInS thin film exhibits a photoelectric conversion property even in the case of as-deposition (without annealing) or low-temperature annealing at approximately 300°C and is therefore a material useful for forming a solar battery at a low process temperature.

### (Example 4)

A photoelectric conversion property of a ZnInS thin film alone, serving as a II-III(In)-VI(S) compound thin film (with inclusion of a zinc element as a Group 12 element) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnInS thin film 202 was formed by RF magnetron sputtering. The compositional ratio of a sputtering target was as follows: Zn:In:S=1:2:4. The film formation atmosphere employed was an argon (Ar) gas atmosphere, and the pressure was set at 0.6 Pa. The film formation temperature was set at room temperature, and the film formation was performed without heating the substrate in a forced manner. The ZnInS thin film 202 had a thickness of 500 nm. After formed, the ZnInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was varied between 300°C and 500°C. On each of the ZnInS thin film 202 having been subjected to as-deposition (without post-annealing) and the ZnInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

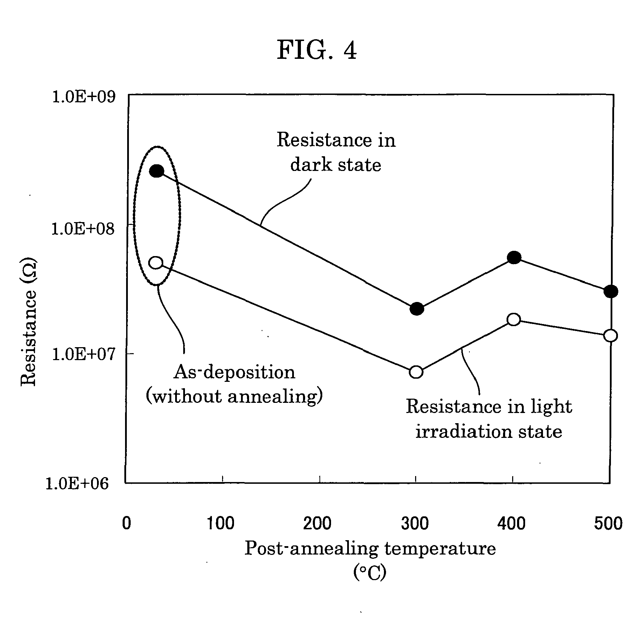

As a photoelectric conversion property, change in the resistance of the thin film caused by light irradiation was examined. Using a halogen lamp as a light source, each ZnInS thin film 202 was irradiated with light having an intensity of 4,000 lux. While a voltage of 5 V was being applied between the Al counter electrodes 203, the current value was measured, and the resistance value was calculated. FIG. 4 is a graph in which a photoelectric conversion property of the ZnInS thin film 202 is shown as a change in its resistance caused by light irradiation. The resistance value of the ZnInS thin film 202 having been subjected to the as-deposition (without post-annealing) and also the resistance value of the ZnInS thin film 202 having been subjected to the post-annealing at 300°C to 500°C decreased because of generation of a photoelectric current caused by the light irradiation. Thus, a ZnInS thin film exhibits a photoelectric conversion property necessary for a constituent film of a thin-film solar battery. It should be particularly noted that a ZnInS thin film exhibits a photoelectric conversion property even in the case of as-deposition (without annealing) or low-temperature annealing at approximately 300°C and is therefore a material useful for forming a solar battery at a low process temperature.

### (Example 5)

A photoelectric conversion property of a ZnSrInS thin film alone, serving as a II-III(In)-VI(S) compound thin film (with inclusion of a zinc element as a Group 12 element and a strontium element as a Group 2 element) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnSrInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnSrInS thin film 202 was formed by co-sputtering of ZnInS and SrS based upon RF magnetron sputtering. The compositional ratios of sputtering targets were as follows: Zn:In:S=1:2:4, and Sr:S=1:1. The film formation atmosphere employed was an argon (Ar) gas atmosphere, and the pressure was set at 0.6 Pa. The sputtering power for the ZnInS was set at 70 W and the sputtering power for the SrS was set at 20 W. The film formation temperature was set at room temperature, and the film formation was performed without heating the substrate in a forced manner. The ZnSrInS thin film had a thickness of 500 nm. After formed, the ZnSrInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnSrInS thin film 202 having been subjected to as-deposition (without post-annealing) and the ZnSrInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnSrInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 4xl0⁷ Ω (before the light irradiation) to 3x10⁶ Ω (after the light irradiation). The resistance value of the thin film having been subjected to the post-annealing at 300°C changed from 1x10⁷ Ω (before the light irradiation) to 6x10⁵ Ω (after the light irradiation). In both these cases, the resistance value decreased because of generation of a photoelectric current caused by the light irradiation. This means that a ZnSrInS thin film exhibits a photoelectric conversion property even in the case of as-deposition (without annealing) or low-temperature annealing at approximately 300°C and is therefore a material useful for forming a solar battery at a low process temperature.

### (Example 6)

A photoelectric conversion property of a ZnInGaS thin film alone, serving as a II-III(In)-VI(S) compound thin film (with inclusion of an indium element and a gallium element as Group 13 elements) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnInGaS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnInGaS thin film 202 was formed by co-sputtering of ZnInS and GaS based upon RF magnetron sputtering. The compositional ratios of sputtering targets were as follows: Zn:In:S=1:2:4, and Ga:S=2:3. The sputtering power for the ZnInS was set at 70 W and the sputtering power for the GaS was set at 30 W. The film formation atmosphere employed was an argon (Ar) gas atmosphere, and the pressure was set at 0.6 Pa. The film formation temperature was set at room temperature, and the film formation was performed without heating the substrate in a forced manner. The ZnInGaS thin film had a thickness of 500 nm. After formed, the ZnInGaS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnInGaS thin film 202 having been subjected to as-deposition (without post-annealing) and the ZnInGaS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnInGaS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 9x10⁶ Ω (before the light irradiation) to 3x10⁵ Ω (after the light irradiation). The resistance value of the thin film having been subjected to the post-annealing at 300°C changed from 1x10⁶ Ω (before the light irradiation) to 5x10⁴ Ω (after the light irradiation). In both these cases, the resistance value decreased because of generation of a photoelectric current caused by the light irradiation. This means that a ZnInGaS thin film exhibits a photoelectric conversion property even in the case of as-deposition (without annealing) or low-temperature annealing at approximately 300°C and is therefore a material useful for forming a solar battery at a low process temperature.

### (Example 7)

A photoelectric conversion property of a ZnInSO thin film alone, serving as a II-III(In)-VI(S) compound thin film (with inclusion of a sulfur element and an oxygen element as Group 16 elements) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnInSO thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnInSO thin film 202 was formed by reactive sputtering with oxygen based upon RF magnetron sputtering. The compositional ratio of a sputtering target was as follows: Zn:In:S=1:2:4. The film formation atmosphere employed was an atmosphere of argon (Ar) gas and oxygen (O₂) gas, and the pressure was set at 0.6 Pa. The flow rate of the oxygen was set at 2.5% of the total flow rate of the gases. The film formation temperature was set at room temperature, and the film formation was performed without heating the substrate in a forced manner. The ZnInSO thin film had a thickness of 500 nm. After formed, the ZnInSO thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnInSO thin film 202 having been subjected to as-deposition (without post-annealing) and the ZnInSO thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnInSO thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 9X10⁷ Ω (before the light irradiation) to 3x10⁶ Ω (after the light irradiation). The resistance value of the thin film having been subjected to the post-annealing at 300°C changed from 1x10⁶ Ω (before the light irradiation) to 3x10⁴ Ω (after the light irradiation). In both these cases, the resistance value decreased because of generation of a photoelectric current caused by the light irradiation. This means that a ZnInSO thin film exhibits a photoelectric conversion property even in the case of as-deposition (without annealing) or low-temperature annealing at approximately 300°C and is therefore a material useful for forming a solar battery at a low process temperature.

### (Example 8)

A photoelectric conversion property of a ZnInSSe thin film alone, serving as a II-III(In)-VI(S) compound thin film (with inclusion of a sulfur element and a selenium element as Group 16 elements) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnInSSe thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnInSSe thin film 202 was formed by co-sputtering of ZnInS and Se based upon RF magnetron sputtering. The compositional ratios of sputtering targets were as follows: Zn:In:S=1:2:4, and Se=1. The sputtering power for the ZnInS was set at 70 W and the sputtering power for the Se was set at 30 W. The film formation atmosphere employed was an argon (Ar) gas atmosphere, and the pressure was set at 0.6 Pa. The film formation temperature was set at room temperature, and the film formation was performed without heating the substrate in a forced manner. The ZnInSSe thin film had a thickness of 500 nm. After formed, the ZnInSSe thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnInSSe thin film 202 having been subjected to as-deposition (without post-annealing) and the ZnInSSe thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnInSSe thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 2x10⁶ Ω (before the light irradiation) to 3x10⁵ Ω (after the light irradiation). The resistance value of the thin film having been subjected to the post-annealing at 300°C changed from 1x10⁶ Ω (before the light irradiation) to 1x10⁴ Ω (after the light irradiation). In both these cases, the resistance value decreased because of generation of a photoelectric current caused by the light irradiation. This means that a ZnInSSe thin film exhibits a photoelectric conversion property even in the case of as-deposition (without annealing) or low-temperature annealing at approximately 300°C and is therefore a material useful for forming a solar battery at a low process temperature.

### (Example 9)

A photoelectric conversion property of a ZnInSTe thin film alone, serving as a II-III(In)-VI(S) compound thin film (with inclusion of a sulfur element and a tellurium element as Group 16 elements) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnInSTe thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnInSTe thin film 202 was formed by co-sputtering of ZnInS and Te based upon RF magnetron sputtering. The compositional ratios of sputtering targets were as follows: Zn:In:S=1:2:4, and Te=1. The sputtering power for the ZnInS was set at 70 W and the sputtering power for the Te was set at 10 W. The film formation atmosphere employed was an argon (Ar) gas atmosphere, and the pressure was set at 0.6 Pa. The film formation temperature was set at room temperature, and the film formation was performed without heating the substrate in a forced manner. The ZnInSTe thin film had a thickness of 500 nm. After formed, the ZnInSTe thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnInSTe thin film 202 having been subjected to as-deposition (without post-annealing) and the ZnInSTe thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnInSTe thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 3x10⁷ Ω before the light irradiation) to 1x10⁶ Ω (after the light irradiation). The resistance value of the thin film having been subjected to the post-annealing at 300°C changed from 4x10⁶ Ω (before the light irradiation) to 8x10⁴ Ω (after the light irradiation). In both these cases, the resistance value decreased because of generation of a photoelectric current caused by the light irradiation. This means that a ZnInSTe thin film exhibits a photoelectric conversion property even in the case of as-deposition (without annealing) or low-temperature annealing at approximately 300°C and is therefore a material useful for forming a solar battery at a low process temperature.

### (Example 10)

A photoelectric conversion property of a ZnMgInS thin film alone, serving as a II-III(In)-VI(S) compound thin film (with inclusion of a magnesium element as a Group 2 element and a zinc element as a Group 12 element) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnMgInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnMgInS thin film 202 was formed by sputtering with the use of a ZnInS target with magnesium tips placed thereon, based upon RF magnetron sputtering. The compositional ratio of the ZnInS target was as follows: Zn:In:S=1:2:4. The sputtering power was set at 70 W. The film formation atmosphere employed was an argon (Ar) gas atmosphere, and the pressure was set at 0.6 Pa. The film formation temperature was set at room temperature, and the film formation was performed without heating the substrate in a forced manner. The ZnMgInS thin film had a thickness of 500 nm. After formed, the ZnMgInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnMgInS thin film 202 having been subjected to as-deposition (without post-annealing) and the ZnMgInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnMgInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 5x10⁷ Ω (before the light irradiation) to 5x10⁶ Ω (after the light irradiation). The resistance value of the thin film having been subjected to the post-annealing at 300°C changed from 8x10⁶ Ω (before the light irradiation) to 1x10⁵ Ω (after the light irradiation). In both these cases, the resistance value decreased because of generation of a photoelectric current caused by the light irradiation. This means that a ZnMgInS thin film exhibits a photoelectric conversion property even in the case of as-deposition (without annealing) or low-temperature annealing at approximately 300°C and is therefore a material useful for forming a solar battery at a low process temperature.

### (Example 11)

A photoelectric conversion property of a ZnBaInS thin film alone, serving as a II-III(In)-VI(S) compound thin film (with inclusion of a barium element as a Group 2 element and a zinc element as a Group 12 element) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnBaInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnBaInS thin film 202 was formed by co-sputtering of ZnInS and BaInS based upon RF magnetron sputtering. The compositional ratios of sputtering targets were as follows: Zn:In:S=1:2:4, and Ba:In:S=1:2:4. The sputtering power for the ZnInS was set at 70 W and the sputtering power for the BaInS was set at 15 W. The film formation atmosphere employed was an argon (Ar) gas atmosphere, and the pressure was set at 0.6 Pa. The film formation temperature was set at room temperature, and the film formation was performed without heating the substrate in a forced manner. The ZnBaInS thin film had a thickness of 500 nm. After formed, the ZnBaInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnBaInS thin film 202 having been subjected to as-deposition (without post-annealing) and the ZnBaInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnBaInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 7xl0⁷ Ω (before the light irradiation) to 3x10⁶ Ω (after the light irradiation). The resistance value of the thin film having been subjected to the post-annealing at 300°C changed from 1x10⁶ Ω (before the light irradiation) to 8x10⁴ Ω (after the light irradiation). In both these cases, the resistance value decreased because of generation of a photoelectric current caused by the light irradiation. This means that a ZnBaInS thin film exhibits a photoelectric conversion property even in the case of as-deposition (without annealing) or low-temperature annealing at approximately 300°C and is therefore a material useful for forming a solar battery at a low process temperature.

### (Example 12)

A photoelectric conversion property of a ZnBInS thin film alone, serving as a II-III(In)-VI(S) compound thin film (with inclusion of a boron element and an indium element as Group 13 elements) used as the n-type layer 104 of the thin film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnBInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnBInS thin film 202 was formed by sputtering with the use of a ZnInS target with boron tips placed thereon, based upon RF magnetron sputtering. The compositional ratio of the ZnInS target was as follows: Zn:In:S=1:2:4. The sputtering power was set at 70 W. The film formation atmosphere employed was an argon (Ar) gas atmosphere, and the pressure was set at 0.6 Pa. The film formation temperature was set at room temperature, and the film formation was performed without heating the substrate in a forced manner. The ZnBInS thin film had a thickness of 500 nm. After formed, the ZnBInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnBInS thin film 202 having been subjected to as-deposition (without post-annealing) and the ZnBInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnBInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 3x10⁷ Ω (before the light irradiation) to 6x10⁶ Ω (after the light irradiation). The resistance value of the thin film having been subjected to the post-annealing at 300°C changed from 2x10⁶ Ω (before the light irradiation) to 9x10⁴ Ω (after the light irradiation). In both these cases, the resistance value decreased because of generation of a photoelectric current caused by the light irradiation. This means that a ZnBInS thin film exhibits a photoelectric conversion property even in the case of as-deposition (without annealing) or low-temperature annealing at approximately 300°C and is therefore a material useful for forming a solar battery at a low process temperature.

### (Example 13)

A photoelectric conversion property of a ZnAlInS thin film alone, serving as a II-III(In)-VI(S) compound thin film (with inclusion of an aluminum element and an indium element as Group 13 elements) used as the n-type layer 104 of the thin-film solar battery in FIG. 1, is now explained. A structure used for measurement of a photoelectric conversion property is shown in the cross-sectional view of FIG. 2, as are the structures of Examples 1, 2 and 3. Specifically, the structure was formed by laying a ZnAlInS thin film 202 and Al thin films (Al electrodes) 203 as counter electrodes over a glass substrate 201 as a support substrate. The Al electrodes were shaped like rectangles with an electrode distance 204 of 0.25 mm and an electrode width (electrode length L with respect to a widthwise direction in FIG. 2) of 5 mm.

The ZnAlInS thin film 202 was formed by sputtering with the use of a ZnInS target with aluminum tips placed thereon, based upon RF magnetron sputtering. The compositional ratio of the ZnInS target was as follows: Zn:In:S=1:2:4. The sputtering power was set at 70 W. The film formation atmosphere employed was an argon (Ar) gas atmosphere, and the pressure was set at 0.6 Pa. The film formation temperature was set at room temperature, and the film formation was performed without heating the substrate in a forced manner. The ZnAlInS thin film had a thickness of 500 nm. After formed, the ZnAlInS thin film was subjected to post-annealing (heat treatment after its formation) using an infrared heating apparatus. The annealing atmosphere employed was a nitrogen (N₂) gas atmosphere, the pressure was set at atmospheric pressure, and the length of time of the post-annealing was 1 hour. The temperature at which the post-annealing was performed was set at 300°C. On each of the ZnAlInS thin film 202 having been subjected to as-deposition (without post-annealing) and the ZnAlInS thin film 202 having been subjected to the post-annealing, the Al thin films 203 were formed as counter electrodes. Heating vapor deposition with a resistance wire was employed to form the Al thin films 203, and they were formed at room temperature. The Al thin films 203 each had a thickness of 150 nm.

As a photoelectric conversion property, change in the resistance of the thin film caused by light irradiation was examined. Using a halogen lamp as a light source, each ZnAlInS thin film 202 was irradiated with light having an intensity of 4,000 lux. While a voltage of 5 V was being applied between the Al counter electrodes 203, the current value was measured, and the resistance value was calculated. The resistance value of the thin film having been subjected to the as-deposition (without post-annealing) changed from 8x10⁶ Ω (before the light irradiation) to 9x10⁵ Ω (after the light irradiation). The resistance value of the thin film having been subjected to the post-annealing at 300°C changed from 2x10⁶ Ω (before the light irradiation) to 7x10⁴ Ω (after the light irradiation). In both these cases, the resistance value decreased because of generation of a photoelectric current caused by the light irradiation. This means that a ZnAlInS thin film exhibits a photoelectric conversion property even in the case of as-deposition (without annealing) or low-temperature annealing at approximately 300°C and is therefore a material useful for forming a solar battery at a low process temperature.

Next, properties of ZnInS thin films alone, each serving as a II-III(In)-VI(S) compound thin film (with inclusion of a zinc element as a Group 12 element) used as the n-type layer 104 of the thin-film solar battery in FIG. 1, will be specifically explained in Examples 14, 15 and 16 below.

### (Example 14)

The results of examinations of the mobility and the electric conduction type (identified by hall effect measurement) of a ZnInS thin film 202 alone, used as the n-type layer 104 of the thin-film solar battery in FIG. 1, are now explained. The hall effect measurement was carried out at room temperature in accordance with the van der Pauw method. A sample of a ZnInS thin film 202 used for the measurement was produced in the same manner as in Example 4. The layer structure shown in FIG. 2 was employed, with Al counter electrodes 203 being four-terminal electrodes. The Al electrodes were shaped like circles with an electrode distance 204 of 9 mm and a diameter of 1 mm each.

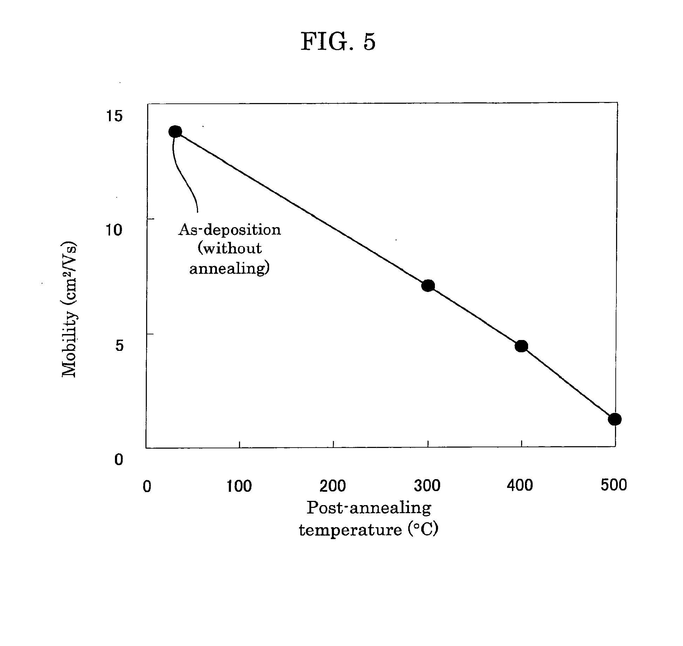

The electric conduction type of the ZnInS thin film 202 having been subjected to as-deposition (without post-annealing) and the electric conduction type of the ZnInS thin film 202 having been subjected to post-annealing at 300°C to 500°C, identified by the hall effect measurement, were both n-type. The mobility of the ZnInS thin film 202 is shown in FIG. 5. The mobility of the as-deposited ZnInS thin was 14 cm²/Vs, and the mobility decreased as the post-annealing temperature increased. It was presumed that the decrease in the mobility upon the high-temperature annealing was caused by the occurrence of a defect related to the heat treatment. Regarding a photoelectric conversion layer of a solar battery, there is no clear reference value for the mobility of the photoelectric conversion layer; nevertheless, it is desirable that the mobility thereof be made as high as possible so as not to hinder the movement of a photoelectric current (generated by light irradiation) to an electrode. Thus, a ZnInS thin film exhibits high mobility even in the case of as-deposition (without annealing) or a low-temperature heat treatment such as annealing at 300°C, and is therefore a material useful for forming a thin-film solar battery at a low process temperature.

### (Example 15)

The compositional ratio between constituent elements of a ZnInS thin film 202 used as the n-type layer 104 of the thin-film solar battery in FIG. 1 is now explained. The compositional ratio was measured by energy dispersive X-ray spectrometry (EDS). A sample of a ZnInS thin film used for the measurement was produced in the same manner as in Example 4. The layer structure shown in FIG. 3 was employed, in which a ZnInS thin film 202 was laid on a glass substrate 201, and the thickness of the ZnInS thin film was 500 nm.

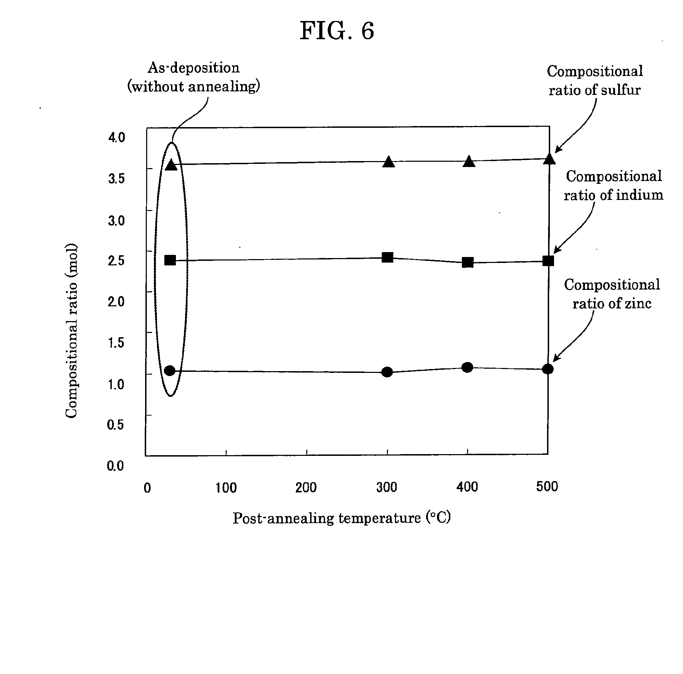

The result of the measurement of the ZnInS thin film by the EDS is shown in FIG. 6. The compositional ratio of Zn to In to S, which were the constituent elements, is shown as a molar ratio. The compositional ratio thereof in the case of as-deposition (without annealing) was as follows: Zn:In:S=1.0:2.4:3.6, and the ratio of Zn to S (Zn/S) was approximately 0.28. Change in the compositional ratio, caused by post-annealing, was hardly observed. Thus, the ZnInS thin film was a stable compound which hardly experienced compositional variation related to the heat treatment.

### (Example 16)

The crystalline state of a ZnInS thin film, used as the n-type layer 104 of the thin-film solar battery in FIG. 1, is now explained based upon a measurement result of X-ray diffraction. A sample of a ZnInS thin film used for the measurement was produced in the same manner as in Example 4. The layer structure shown in FIG. 3 was employed, in which a ZnInS thin film 202 was laid on a glass substrate 201, and the thickness of the ZnInS thin film was 500 nm.

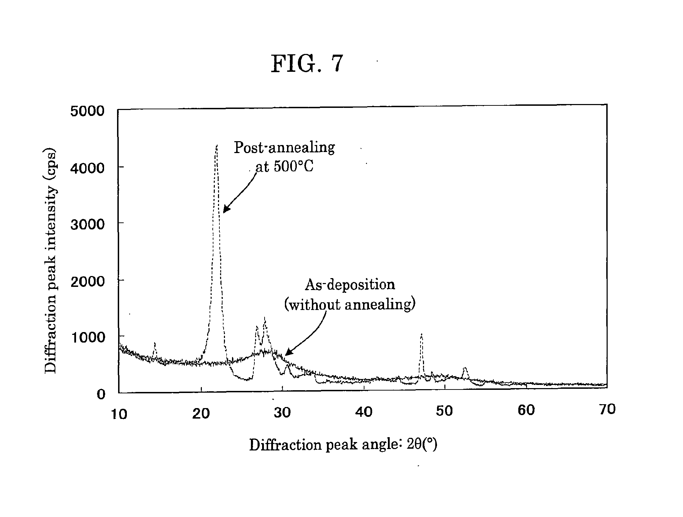

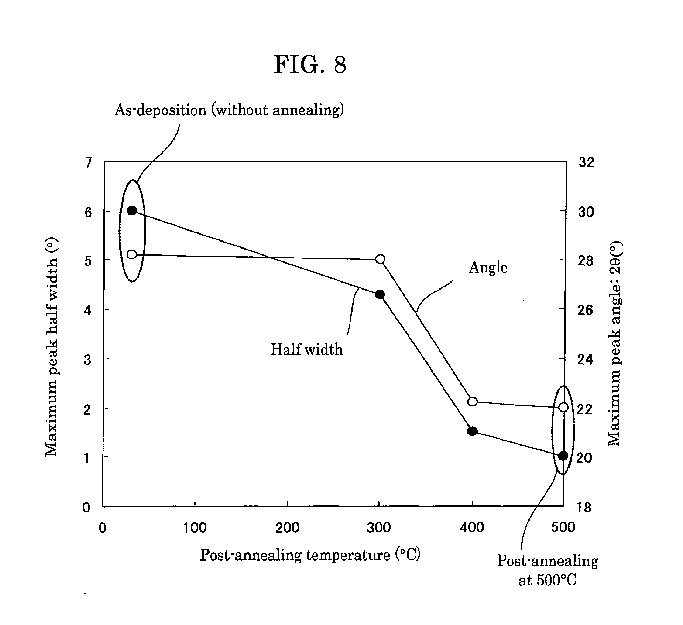

The measurement of X-ray diffraction was carried out at a voltage of 45 kV and an electric current of 40 mA, with a Cu-kα ray. X-ray diffraction profiles in relation to the ZnInS thin film are shown in FIG. 7. The diffraction profile of the ZnInS thin film in the case of as-deposition (without annealing) broadened with no clear diffraction peak observed. It was found that the as-deposited thin film was an aggregate of very small crystal grains. Meanwhile, regarding the diffraction profile of the ZnInS thin film having been subjected to post-annealing (500°C), an intense diffraction peak was observed in the vicinity of 22°. It was found that the thin film having been subjected to the annealing had larger crystal grains than the thin film in the as-deposited state and was an oriented film with the crystal grains being oriented in a certain crystal direction. Regarding a diffraction peak with a maximum intensity, changes in angle and half width according to the post-annealing temperature are shown in FIG. 8. The angle and the half width regarding an X-ray diffraction peak of the ZnInS thin film changed in phases according to the post-annealing temperature. Regarding the as-deposited thin film and the thin film having been subjected to post-annealing at 300°C, a broad diffraction peak with a half width of approximately 5° was observed in the vicinity of a diffraction angle of 28°, whereas regarding the thin film having been subjected to post-annealing at 400°C and 500°C, a diffraction peak with a half width of approximately 1° was observed in the vicinity of a diffraction angle of 22°. Based upon this result, the half width of a diffraction peak could be defined as greater than 3° as a threshold value showing the state of a ZnInS thin film produced by as-deposition or a low-temperature process involving post-annealing at 300°C.

The foregoing demonstrated that each of the II-III(In)-VI(S) compound thin films, wherein Cd (as a Group 12 element), Mn (as a Group 7 element), Sr (as a Group 2 element) and Zn (as a Group 12 element) were respectively used in Examples of 1, 2, 3 and 4, and Zn (as a Group 12 element), Sr (as a Group 2 element), a combination of In and Ga (as Group 13 elements), a combination of S and O (as Group 16 elements) and a combination of S and Se (as Group 16 elements) were respectively used in Examples 5, 6, 7 and 8, yielded a photoelectric conversion property even in a production method involving as-deposition or a low-temperature process such as post-annealing at 300°C, subsequent to the film formation by sputtering at room temperature without heating of the substrate, and therefore had a property suitable for a photoelectric conversion layer of a solar battery. Also, Examples 4, 14, 15 and 16 demonstrated that each of the II-III(In)-VI(S) compound thin films, wherein Zn (as a Group 12 element) was used, yielded a photoelectric conversion property, was of n-type as a conduction type and had high mobility (7 cm²/Vs) even in a production method involving as-deposition or a low-temperature process such as post-annealing at 300°C, subsequent to the film formation by sputtering at room temperature, and thus demonstrated that each of the thin films had properties suitable for a photoelectric conversion layer of a solar battery. Further, it was demonstrated that these properties could be obtained even in an amorphous state with the half width of an X-ray diffraction peak being greater than 3°.

By using, as a photoelectric conversion layer, any of the II-III(In)-VI(S) compound thin films produced by as-deposition or low-temperature annealing at approximately 300°C, subsequent to the film formation at room temperature, it was possible to shorten the time spent in increasing and lowering the temperature in the production process. Therefore, high throughput in the production of thin-film solar batteries can be achieved, which leads to reduction in production costs. Also, since the film formation is performed at room temperature by means of sputtering, a low-temperature process in which heating of the support substrate 101 was not required could be employed, thereby making it possible to utilize a low-cost plastic substrate as the support substrate 101. Further, it was found that there were many merits including the fact that the occurrence of crack formation and film peeling, caused by residual stress relaxation related to high-temperature annealing, could be reduced.

Next, the structures, production methods and electricity-generating properties of II-III(In)-VI(S) compound thin films, which were each used as the n-type layer 104, will be specifically explained based upon Examples 17 to 21.

### (Example 17)

In a thin-film solar battery having the structure shown in FIG. 1, AgInTe was used for the p-type layer 103, ZnInS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 500 nm.

ZnInS used for the n-type layer 104 was deposited by RF magnetron sputtering. The compositional ratio of a sputtering target was as follows: Zn:In:S=1:2:4. With the input power being set at 0.1 kW, the ZnInS was deposited in an argon (Ar) gas atmosphere. The layer thickness thereof was 500 nm. All these members were deposited at room temperature (without carrying out heating of the substrate in a forced manner).

After the deposition of the ZnInS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

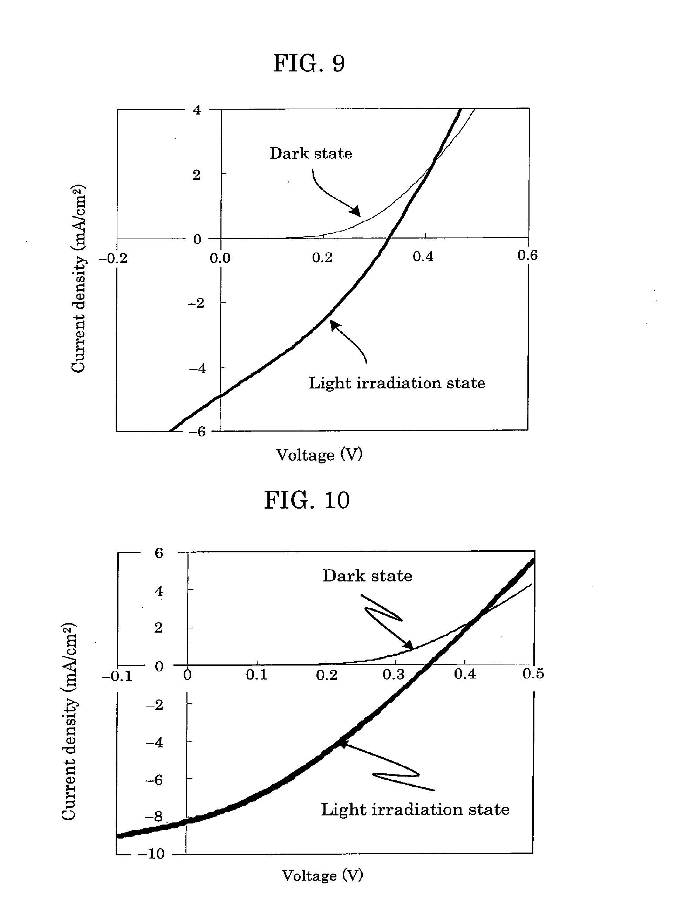

A current-voltage (I-V) characteristic as an electricity-generating property of the thin-film solar battery of Example 17 is shown in FIG. 9. For evaluation of the I-V characteristic, a solar simulator with an artificial sunlight source with an intensity of 100 mW/cm² and an AM (air mass) of 1.5 was used. While a bias voltage in the range of ―0.2 V to + 0.6 V was being applied to the side of the Mo electrode as the first electrode 102, measurement was carried out with the side of the ZnO:Al electrode as the second electrode 105 being earthed. An I-V curve in a dark state and an I-V curve in a light irradiation state are shown in FIG. 9. Such an electricity-generating property was obtained that the I-V curve shifted toward the negative electric current side by light irradiation and an electric current flowed even when there was no bias (0V).

Thus, the thin-film solar battery wherein ZnInS was used for the n-type layer 104, AgInTe was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

### (Example 18)

In Example 17 above, a thin-film solar battery containing a tellurium compound used for the p-type layer 103 was described. In Example 18, a thin-film solar battery containing CuInS, which is a sulfide material as a material other than any tellurium compound, used for the p-type layer 103 is described. In a thin-film solar battery having the structure shown in FIG. 1, CuInS was used for the p-type layer 103, ZnInS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

CuInS used for the p-type layer 103 was deposited by RF magnetron sputtering. The compositional ratio of a sputtering target was as follows: Cu:In:S=1:1:2. With the input power being set at 0.2 kW, the AgInTe was deposited in an argon (Ar) gas atmosphere. The layer thickness thereof was 500 nm.

ZnInS used for the n-type layer 104 was deposited by co-sputtering in which two sputtering targets, i.e., ZnS and InS, were used. The compositional ratios of the sputtering targets were as follows: Zn:S=1:1, and In:S=2:3. RF magnetron sputtering was employed, with the input powers for the ZnS target and the InS target being set at 0.2 kW and 0.1 kW respectively. The ZnInS was deposited in an argon (Ar) gas atmosphere. The layer thickness of the ZnInS was 500 nm. All these members were deposited at room temperature (without carrying out heating of the substrate in a forced manner).

After the deposition of the ZnInS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

A current-voltage (I-V) characteristic as an electricity-generating property of the thin-film solar battery of Example 18 is shown in FIG. 10. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a dark state and an I-V curve in a light irradiation state are shown in FIG. 10. Such an electricity-generating property was obtained that the I-V curve shifted toward the negative electric current side by light irradiation and an electric current flowed even when there was no bias (0V).

Thus, the thin-film solar battery wherein ZnInS was used for the n-type layer 104, CuInS that is a sulfide compound as a material other than any tellurium compound was used for the p-type layer 103, and all the members were produced by sputtering yielded an electricity-generating property. The production of the members only by sputtering made it possible to produce uniform thin films with large areas and to achieve reduction in production costs by the use of a single film forming apparatus.

### (Example 19)

In Examples 17 and 18 above, post-annealing was carried out at 300°C after the deposition of the ZnInS. In Example 19, differences in electricity-generating property, related to the post-annealing temperature, are explained.

In a thin-film solar battery having the structure shown in FIG. 1, AgInTe was used for the p-type layer 103, ZnInS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 500 nm.

ZnInS used for the n-type layer 104 was formed by co-sputtering in which two sputtering targets, i.e., ZnS and InS, were used. The compositional ratios of the sputtering targets were as follows: Zn:S=1:1, and In:S=2:3. RF magnetron sputtering was employed, with the input powers for the ZnS target and the InS target being set at 0.2 kW and 0.1 kW respectively. The ZnInS was deposited in an argon (Ar) gas atmosphere. The layer thickness of the ZnInS was 500 nm. All these members were deposited at room temperature (without carrying out heating of the substrate in a forced manner).

After the deposition of the ZnInS, post-annealing was carried out. Using an infrared heating furnace, the post-annealing was carried out in a nitrogen atmosphere. The pressure was set at atmospheric pressure. The post-annealing temperatures were set at 100°C, 200°C, 300°C and 400°C. In addition, a (non-annealed) sample not subjected to annealing, in other words a sample simply formed at room temperature, was prepared.

After the annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

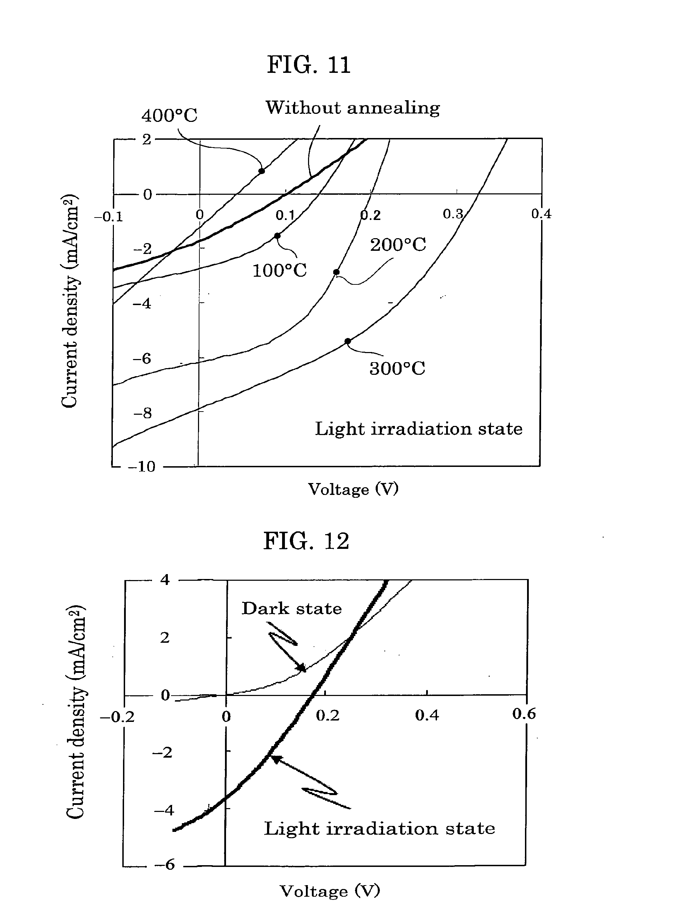

A current-voltage (I-V) characteristic as an electricity-generating property of the thin-film solar battery of Example 19 is shown in FIG. 11. For evaluation of the I-V characteristic, a solar simulator with an artificial sunlight source with an intensity of 100 mW/cm² and an AM (air mass) of 1.5 was used. While a bias voltage in the range of ―0.1 V to + 0.4 V was being applied to the side of the Mo electrode as the first electrode 102, measurement was carried out with the side of the ZnO:Al electrode as the second electrode 105 being earthed. In FIG. 11, the horizontal axis denotes applied voltage, the vertical axis denotes current density, and only an I-V curve in a light irradiation state is shown. I-V curves respectively related to a non-annealed state and post-annealing temperatures of 100°C, 200°C, 300°C and 400°C are shown in FIG. 11. Indices that show properties of a solar battery include open-circuit voltage (Voc) and short-circuit current (Isc). The greater the open-circuit voltage (Voc) and the short-circuit current (Isc) are, the better properties the solar battery has. Regarding the I-V characteristic shown in FIG. 11, the x-axis intercept corresponds to the short-circuit current (Isc), and the y-axis intercept corresponds to the open-circuit voltage (Voc). From the non-annealed state to the post-annealing temperature of 300°C, both the short-circuit current (Isc) and the open-circuit voltage (Voc) increased as the post-annealing temperature rose. However, upon increase of the post-annealing temperature to 400°C, both the short-circuit current (Isc) and the open-circuit voltage (Voc) decreased. This result shows that the most suitable post-annealing temperature is 300°C or so.

Thus, regarding the thin-film solar battery containing ZnInS used for the n-type layer 104, α favorable electricity-generating property was obtained by carrying out low-temperature heat treatment at a post-annealing temperature of 300°C.

### (Example 20)

Regarding a structure obtained by laying the p-type layer 103 and the n-type layer 104 in a different order in the thin-film solar battery shown in FIG. 1, differences in electricity-generating property are now explained. Specifically, the structure was such that ZnO:Al used for the first electrode 102, ZnInS used for a II-III(In)-VI(S) compound thin film as the n-type layer, AgInTe used for the p-type layer, and molybdenum (Mo) used for the second electrode 105 were deposited in this order over the support substrate 101. A glass substrate was used as the support substrate 101.

The following specifically explains the production method.

ZnO:Al used for the first electrode 102 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm.

ZnInS used for the n-type layer 104 was deposited by RF magnetron sputtering. The compositional ratio of a sputtering target was as follows: Zn:In:S=1:2:4. With the input power being set at 0.1 kW, the ZnInS was deposited in an argon (Ar) gas atmosphere. The layer thickness thereof was 500 nm.

AgInTe used for the p-type layer was formed by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 500 nm. All these members were deposited at room temperature (without carrying out heating of the substrate in a forced manner).

After the deposition of the AgInTe, post-annealing was carried out. Using an infrared heating furnace, the post-annealing was carried out in a nitrogen atmosphere. The post-annealing temperature was set at 250°C, and the pressure was set at atmospheric pressure. After the post-annealing, Mo used for the second electrode 105 was deposited by DC magnetron sputtering. With the input power being set at 3 kW, the Mo was deposited in an argon (Ar) gas atmosphere. The layer thickness thereof was 200 nm. The deposition temperature was set at room temperature (without carrying out heating of the substrate in a forced manner).

A current-voltage (I-V) characteristic as an electricity-generating property of the thin-film solar battery of Example 20 is shown in FIG. 12. For evaluation of the I-V characteristic, a solar simulator with an artificial sunlight source with an intensity of 100 mW/cm² and an AM (air mass) of 1.5 was used. While a bias voltage in the range of ―0.1 V to + 0.6 V was being applied to the side of the Mo electrode as the second electrode 105, measurement was carried out with the side of the ZnO:Al electrode as the first electrode 102 being earthed. An I-V curve in a dark state and an I-V curve in a light irradiation state are shown in FIG. 12. Such an electricity-generating property was obtained that the I-V curve shifted toward the negative electric current side by light irradiation and an electric current flowed even when there was no bias (0V).

FIG. 9 shows a result in relation to Example 17, yielded by earlier depositing AgInTe for the p-type layer, and then depositing ZnInS for the n-type layer. Meanwhile, FIG. 12 shows a result in relation to Example 20, yielded by earlier depositing ZnInS for the n-type layer, and then depositing AgInTe for the p-type layer. Thus, even when the order in which ZnInS for the n-type layer and AgInTe for the p-type layer were laid was changed, an electricity-generating property was obtained.

### (Example 21)

In a thin-film solar battery having the structure shown in FIG. 1, AgInTe was used for the p-type layer 103, ZnSrInS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input energy being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 500 nm.

ZnSrInS used for the n-type layer 104 was deposited by co-sputtering of ZnInS and SrS based upon RF magnetron sputtering. The compositional ratios of sputtering targets were as follows: Zn:In:S=1:2:4, and Sr:S=1:1. The ZnSrInS was deposited in an argon (Ar) gas atmosphere, and the pressure was set at 0.6 Pa. The sputtering powers for the ZnInS and the SrS were set at 70 W and 20 W respectively. The deposition temperature was set at room temperature (without carrying out heating of the substrate in a forced manner). The layer thickness of the ZnSrInS was 500 nm.

After the deposition of the ZnSrInS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

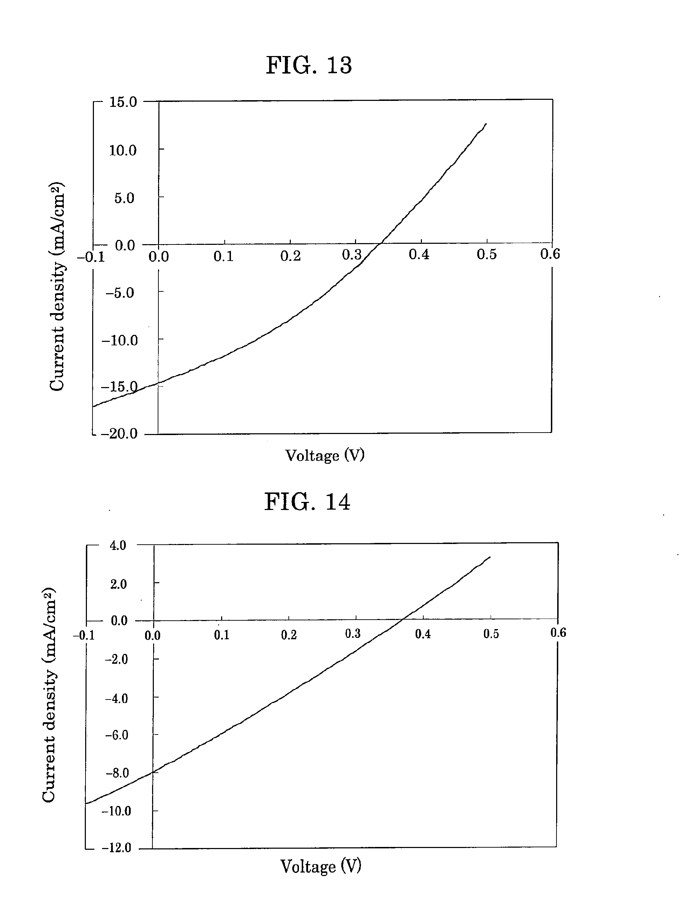

A current-voltage (I-V) characteristic as an electricity-generating property of the thin-film solar battery of Example 21 is shown in FIG. 13. For evaluation of the I-V characteristic, a solar simulator with an artificial sunlight source with an intensity of 100 mW/cm² and an AM (air mass) of 1.5 was used. While a bias voltage in the range of ―0.2 V to + 0.6 V was being applied to the side of the Mo electrode as the first electrode 102, measurement was carried out with the side of the ZnO:Al electrode as the second electrode 105 being earthed. An I-V curve in a light irradiation state is shown in FIG. 13. Such an electricity-generating property was obtained that the I-V curve shifted toward the negative electric current side by light irradiation and an electric current flowed even when there was no bias (0V).

Thus, the thin-film solar battery wherein ZnSrInS was used for the n-type layer 104, AgInTe was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

### (Example 22)

In a thin-film solar battery having the structure shown in FIG. 1, CuInS was used for the p-type layer 103, ZnInSO was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

CuInS used for the p-type layer 103 was deposited by RF magnetron sputtering. The compositional ratio of a sputtering target was as follows: Cu:In:S=1:1:2. With the input power being set at 0.2 kW, the CuInS was deposited in an argon (Ar) gas atmosphere. The layer thickness thereof was 500 nm.

ZnInSO used for the n-type layer 104 was deposited by reactive sputtering with oxygen based upon RF magnetron sputtering. The compositional ratio of a sputtering target was as follows: Zn:In:S=1:2:4. The ZnInSO was deposited in an atmosphere of argon (Ar) gas and oxygen (O₂) gas, and the pressure was set at 0.6 Pa. The flow rate of the oxygen was set at 2.5% of the total flow rate of the gases. The deposition temperature was set at room temperature (without carrying out heating of the substrate in a forced manner). The thickness of the ZnInSO thin film was 500 nm.

After the deposition of the ZnInSO, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

A current-voltage (I-V) characteristic as an electricity-generating property of the thin-film solar battery of Example 22 is shown in FIG. 14. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a light irradiation state is shown in FIG. 14. Such an electricity-generating property was obtained that the I-V curve shifted toward the negative electric current side by light irradiation and an electric current flowed even when there was no bias (0V).

Thus, the thin-film solar battery wherein ZnInSO was used for the n-type layer 104, CuInS was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

### (Example 23)

In a thin-film solar battery having the structure shown in FIG. 1, CuInS was used for the p-type layer 103, ZnInGaS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

CuInS used for the p-type layer 103 was deposited by RF magnetron sputtering. The compositional ratio of a sputtering target was as follows: Cu:In:S=1:1:2. With the input power being set at 0.2 kW, the CuInS was deposited in anargon (Ar) gas atmosphere. The layer thickness thereof was 500 nm.

ZnInGaS used for the n-type layer 104 was deposited by co-sputtering of ZnInS and ZnGaS based upon RF magnetron sputtering. The compositional ratios of sputtering targets were as follows: Zn:In:S=1:2:4, and Zn:Ga:S=1:2:4. The ZnInGaS was deposited in an argon (Ar) gas atmosphere, and the pressure was set at 0.6 Pa. The sputtering powers for the ZnInS and the ZnGaS were set at 70 W and 30 W respectively. The deposition temperature was set at room temperature (without carrying out heating of the substrate in a forced manner). The layer thickness of the ZnInGaS was 500 nm.

After the deposition of the ZnInGaS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:A1 used for the second electode 105 was deposited by DC magnetron sputtering. As a sputtering target, ZnO (Zn:0=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

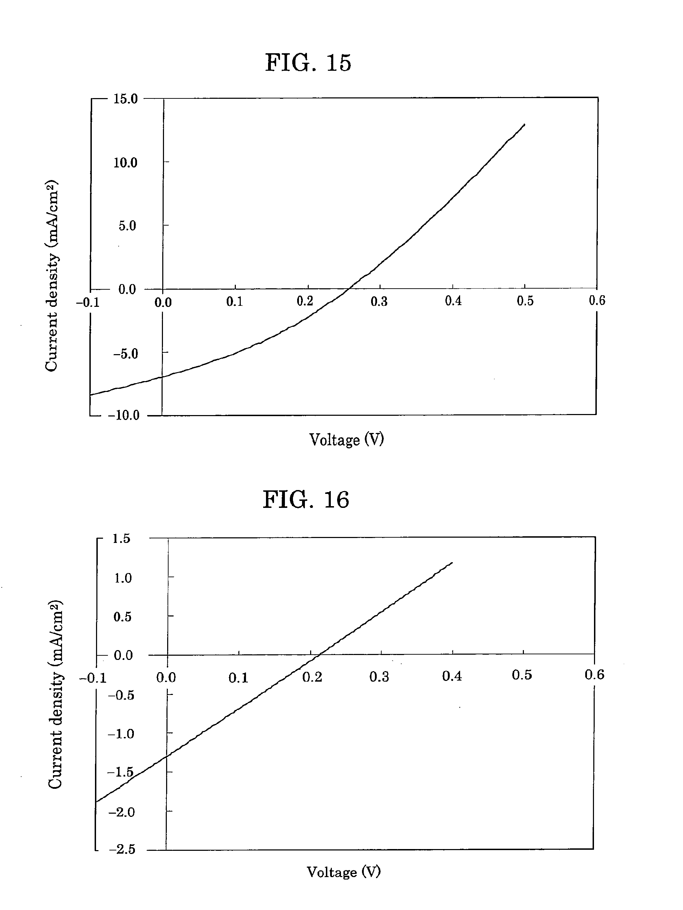

A current-voltage (I-V) characteristic as an electricity-generating property of the thin-film solar battery of Example 23 is shown in FIG. 15. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a light irradiation state is shown in FIG. 15. Such an electricity-generating property was obtained that the I-V curve shifted toward the negative electric current side by light irradiation and an electric current flowed even when there was no bias (0V).

Thus, the thin-film solar battery wherein ZnInGaS was used for the n-type layer 104, CuInS was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

### (Example 24)

In a thin-film solar battery having the structure shown in FIG. 1, AgInTe was used for the p-type layer 103, ZnMnInS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 0.2 kW, the AgInTe was deposited in an argon (Ar) gas atmosphere. The layer thickness thereof was 500 nm.

ZnMnInS used for the n-type layer 104 was deposited by co-sputtering of ZnInS and MnInS based upon RF magnetron sputtering. The compositional ratios of sputtering targets were as follows: Zn:ln:S=1:2:4, and Mn:In:S=1:2:4. The ZnMnInS was deposited in an argon (Ar) gas atmosphere, and the pressure was set at 0.6 Pa. The sputtering powers for the ZnInS and the MnInS were set at 70 W and 30 W respectively. The deposition temperature was set at room temperature (without carrying out heating of the substrate in a forced manner). The layer thickness of the ZnMnInS was 500 nm.

After the deposition of the ZnMnInS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

A current-voltage (I-V) characteristic as an electricity-generating property of the thin-film solar battery of Example 24 is shown in FIG. 16. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a light irradiation state is shown in FIG. 16. Such an electricity-generating property was obtained that the I-V curve shifted toward the negative electric current side by light irradiation and an electric current flowed even when there was no bias (0V).

Thus, the thin-film solar battery wherein ZnMnInS was used for the n-type layer 104, AgInTe was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

### (Example 25)

In a thin-film solar battery having the structure shown in FIG. 1, AgInTe was used for the p-type layer 103, ZnSrInGaS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 500 nm.

ZnSrInGaS used for the n-type layer 104 was deposited by co-sputtering of ZnGaS and SrInS based upon RF magnetron sputtering. The compositional ratios of sputtering targets were as follows: Zn:Ga:S=1:2:4, and Sr:In:S=1:2:4. The ZnSrInGaS was deposited in an argon (Ar) gas atmosphere, and the pressure was set at 0.6 Pa. The sputtering powers for the ZnGaS and the SrInS were set at 40 W and 70 W respectively. The deposition temperature was set at room temperature (without carrying out heating of the substrate in a forced manner). The layer thickness of the ZnSrInGaS was 500 nm.

After the deposition of the ZnSrInGaS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:0=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

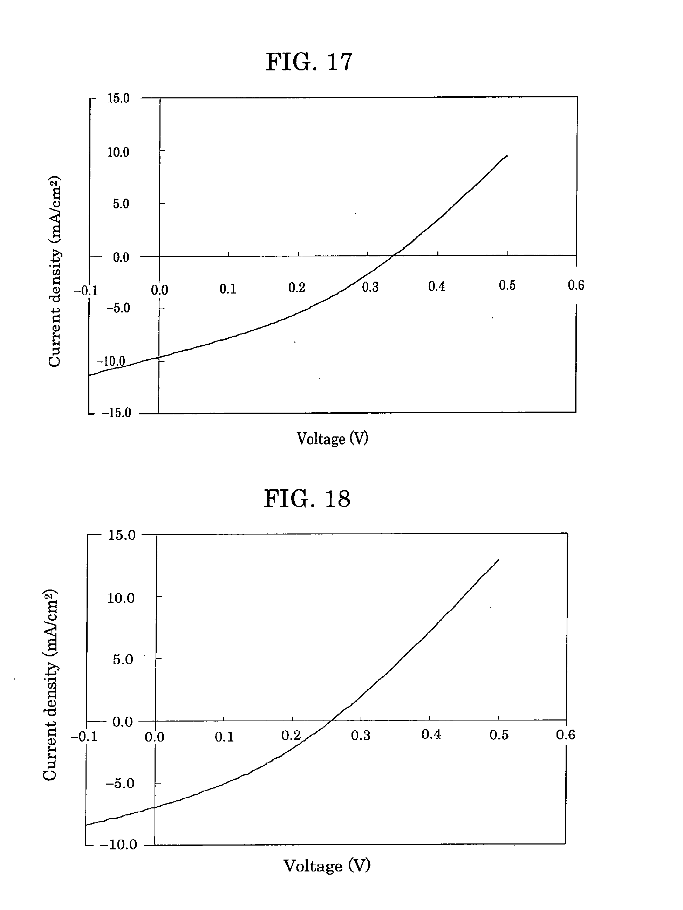

A current-voltage (I-V) characteristic as an electricity-generating property of the thin-film solar battery of Example 25 is shown in FIG. 17. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a light irradiation state is shown in FIG. 17. Such an electricity-generating property was obtained that the I-V curve shifted toward the negative electric current side by light irradiation and an electric current flowed even when there was no bias (0V).

Thus, the thin-film solar battery wherein ZnSrInGaS was used for the n-type layer 104, AgInTe was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

### (Example 26)

In a thin-film solar battery having the structure shown in FIG. 1, CuInS was used for the p-type layer 103, CaInS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

CuInS used for the p-type layer 103 was deposited by RF magnetron sputtering. The compositional ratio of a sputtering target was as follows: Cu:In:S=1:1:2. With the input power being set at 1 kW, the CuInS was deposited in an argon (Ar) gas atmosphere. The layer thickness thereof was 500 nm.

CaInS used for the n-type layer 104 was deposited by RF magnetron sputtering. The compositional ratio of a sputtering target was as follows: Ca:In:S=1:2:4. The CaInS deposited in an argon (Ar) gas atmosphere, and the pressure was set at 0.6 Pa. The sputtering power was set at 70 W. The deposition temperature was set at room temperature (without carrying out heating of the substrate in a forced manner). The layer thickness of the CaInS was 500 nm.

After the deposition of the CaInS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

A current-voltage (I-V) characteristic as an electricity-generating property of the thin-film solar battery of Example 26 is shown in FIG. 18. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a light irradiation state is shown in FIG. 18. Such an electricity-generating property was obtained that the I-V curve shifted toward the negative electric current side by light irradiation and an electric current flowed even when there was no bias (0V).

Thus, the thin-film solar battery wherein CaInS was used for the n-type layer 104, CuInS was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

### (Example 27)

In a thin-film solar battery having the structure shown in FIG. 1, Cu2S was used for the p-type layer 103, ZnInS was used for a II-III(In)-VI(S) compound thin film as the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

Cu2S used for the p-type layer 103 was deposited by RF magnetron sputtering. The compositional ratio of a sputtering target was as follows: Cu:S=1:2. With the input power being set at 1 kW, the Cu2S was deposited in an argon (Ar) gas atmosphere. The layer thickness thereof was 500 nm. Note that when a photoelectric conversion property of the Cu2S thin film alone was examined using a method similar to that in Examples 1 to 8, a photoelectric current was not generated by light irradiation.

ZnInS used for the n-type layer 104 was deposited by RF magnetron sputtering. The compositional ratio of a sputtering target was as follows: Zn:In:S=1:2:4. The ZnInS was deposited in an argon (Ar) gas atmosphere, and the pressure was set at 0.6 Pa. The sputtering power was set at 70 W. The deposition temperature was set at room temperature (without carrying out heating of the substrate in a forced manner). The layer thickness of the ZnInS was 500 nm.

After the deposition of the ZnInS, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ZnO:Al used for the second electrode 105 was deposited by DC magnetron sputtering. As a sputtering target, ZnO (Zn:0=1:1) with 3% of aluminum added thereto was used. With the input power being set at 1 kW, the ZnO:Al was deposited in an argon (Ar) gas atmosphere. The layer thickness thereof was 150 nm. The deposition temperature was set at room temperature (without carrying out heating of the substrate in a forced manner).

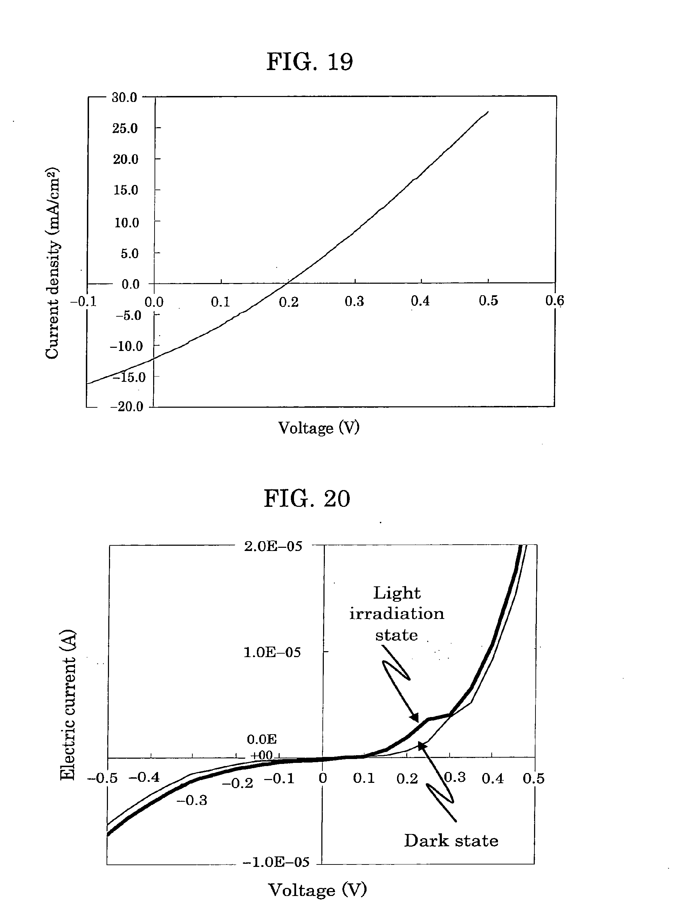

A current-voltage (I-V) characteristic as an electricity-generating property of the thin-film solar battery of Example 27 is shown in FIG. 19. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a light irradiation state is shown in FIG. 19. Such an electricity-generating property was obtained that the I-V curve shifted toward the negative electric current side by light irradiation and an electric current flowed even when there was no bias (0V).

Thus, the thin-film solar battery wherein ZnInS was used for the n-type layer 104, Cu2S was used for the p-type layer 103, and all of the n-type layer 104, the p-type layer 103, the Mo first electrode 102 and the ZnO:Al second electrode (transparent conductive film) 105 were produced by sputtering yielded an electricity-generating property. The production of these members only by sputtering made it possible to produce uniform thin films with large areas and to achieve reduction in production costs by the use of a single film forming apparatus.

Next, the structures of thin-film solar batteries each including, as an n-type layer, an n-type semiconductor material which is not the II-III(In)-VI(S) compound thin film, and results in which no electricity-generating property was obtained will be explained based upon Comparative Examples 1 and 2.

### (Comparative Example 1)

In a thin-film solar battery having the structure shown in FIG. 1, AgInTe was used for the p-type layer 103, ZnO was used for the n-type layer 104, molybdenum (Mo) was used for the first electrode 102, and ITO was used for the second electrode 105, with all these members deposited by sputtering. A glass substrate was used as the support substrate 101.

The following specifically explains the production method.

Mo used for the first electrode 102 was formed by DC magnetron sputtering. With the input power being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 1,000 nm.

ZnO used for the n-type layer 104 was formed by RF magnetron sputtering. The compositional ratio of a sputtering target was as follows: Zn:O=1:1. With the input power being set at 0.1 kW, the ZnO was deposited in an argon (Ar) gas atmosphere. The layer thickness thereof was 150 nm. All these members were deposited at room temperature (without carrying out heating of the substrate in a forced manner).

After the deposition of the ZnO, post-annealing was carried out. Using an infrared heating furnace, the post-annealing was carried out in a nitrogen atmosphere. The post-annealing temperature was set at 250°C, and the pressure was set at atmospheric pressure.

After the post-annealing, ITO used for the second electrode 105 was deposited by DC magnetron sputtering. As a sputtering target, In₂O₃ with 5 mol% of SnO₂ added thereto was used. With the input power being set at 0.4 kW, the ITO was deposited in a mixed atmosphere of Argon (Ar) gas and oxygen (O₂) gas, in which the O₂ gas was added in an amount of 5% with respect to the Ar gas. The layer thickness thereof was 150 nm. The deposition temperature was set at room temperature (without carrying out heating of the substrate in a forced manner).

A current-voltage (I-V) characteristic as an electricity-generating property of the thin-film solar battery of Comparative Example 1 is shown in FIG. 20. As a light source for evaluation of the I-V characteristic, a halogen lamp with an illuminance of 4,000 lux was used. While a bias voltage in the range of ―0.5 V to + 0.5 V was being applied to the side of the Mo electrode as the first electrode 102, measurement was carried out with the side of the ITO electrode as the second electrode 105 being earthed. An I-V curve in a dark state and an I-V curve in a light irradiation state are shown in FIG. 20. Change in the I-V curve caused by light irradiation was not observed, and the I-V curve was a curve passing through the point 0.

Thus, regarding the thin-film solar battery wherein ZnO as an n-type semiconductor material different from the II-III(In)-VI(S) compound thin film was used for the n-type layer 104, change in the I-V curve caused by light irradiation was not confirmed, and so no electricity- generating property was confirmed.

### (Comparative Example 2)

In a thin-film solar battery having the structure shown in FIG. 1, AgInTe was used for the p-type layer 103, a laminated film of ZnS/ZnO was used for the n-type layer 104, molybdenum (Mo) was used for the first electrode 102, and ITO was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 500 nm.

A laminated film of ZnS/ZnO as the n-type layer 104 was formed by RF magnetron sputtering. The compositional ratio of a sputtering target for the ZnS was as follows: Zn:S=1:1. With the input power being set at 0.2 kW, the ZnS was deposited in an argon (Ar) gas atmosphere. The layer thickness thereof was 50 nm. The compositional ratio of a sputtering target for the ZnO was as follows: Zn:O=1:1. With the input power being set at 0.1 kW, the ZnO was deposited in an argon (Ar) gas atmosphere. The layer thickness thereof was 100 nm. All these members were formed at room temperature (without carrying out heating of the substrate in a forced manner).

After the formation of the laminated film of ZnS/ZnO, post-annealing was carried out. Using an infrared heating furnace, the post-annealing was carried out in a nitrogen atmosphere. The post-annealing temperature was set at 300°C, and the pressure was set at atmospheric pressure.

After the post-annealing, ITO as the second electrode 105 was deposited by DC magnetron sputtering. As a sputtering target, In₂O₃ with 5 mol% of SnO₂ added thereto was used. With the input power being set at 0.4 kW, the ITO was deposited in a mixed atmosphere of Argon (Ar) gas and oxygen (O₂) gas, in which the O₂ gas was added in an amount of 5% with respect to the Ar gas. The layer thickness thereof was 150 nm. The deposition temperature was set at room temperature (without carrying out heating of the substrate in a forced manner).

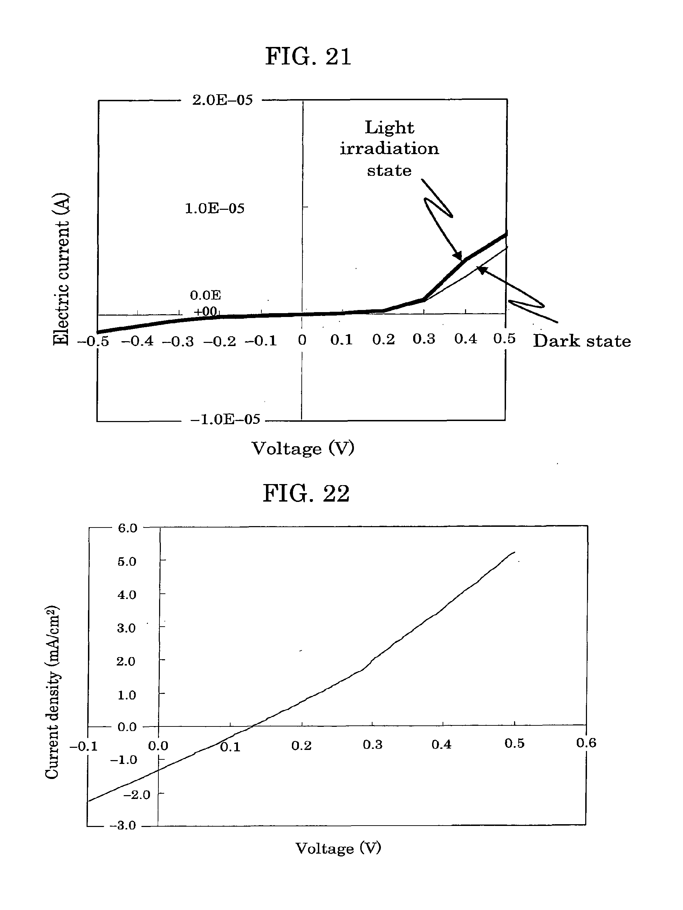

A current-voltage (I-V) characteristic as an electricity-generating property of the thin-film solar battery of Comparative Example 2 is shown in FIG. 21. As a light source for evaluation of the I-V characteristic, a halogen lamp with an illuminance of 4,000 lux was used. While a bias voltage in the range of ―0.5 V to + 0.5 V was being applied to the side of the Mo electrode as the first electrode 102, measurement was carried out with the side of the ITO electrode as the second electrode 105 being earthed. An I-V curve in a dark state and an I-V curve in a light irradiation state are shown in FIG. 21. Change in the I-V curve caused by light irradiation was not observed, and the I-V curve was a curve passing through the point 0.

Thus, regarding the thin-film solar battery wherein a laminated film of ZnS/ZnO as an n-type semiconductor material different from the II-III(In)-VI(S) compound thin film was used for the n-type layer 104, change in the I-V curve caused by light irradiation was not confirmed, and so no electricity-generating property was confirmed.

### (Comparative Example 3)

In a thin-film solar battery having the structure shown in FIG. 1, AgInTe was used for the p-type layer 103, InS was used for the n-type layer 104, molybdenum (Mo) was used for the first electrode 102, and ZnO:Al was used for the second electrode 105, with all these members deposited by sputtering. A glass substrate was used as the support substrate 101.

The following specifically explains the production method.

Mo used for the first electrode 102 was deposited by DC magnetron sputtering. With the input power being set at 3 kW, the Mo was deposited in an argon (Ar) gas atmosphere. The layer thickness thereof was 200 nm.

AgInTe used for the p-type layer 103 was deposited by RF magnetron sputtering. The compositional ratio of a sputtering target was as follows: Ag:In:Te=1:1:2. With the input power being set at 1 kW, the AgInTe was deposited in an argon (Ar) gas atmosphere. The layer thickness thereof was 1,000 nm.

InS used for the n-type layer 104 was deposited by RF magnetron sputtering. The compositional ratio of a sputtering target was as follows: In:S=2:3. With the input power being set at 0.7 kW, the InS was deposited in an argon (Ar) gas atmosphere. The layer thickness thereof was 150 nm. All these members were formed at room temperature (without carrying out heating of the substrate in a forced manner).

After the deposition of the InS, post-annealing was carried out. Using an infrared heating furnace, the post-annealing was carried out in a nitrogen atmosphere. The post-annealing temperature was set at 250°C, and the pressure was set at atmospheric pressure.

After the post-annealing, ZnO:Al used for the second electrode 105 was deposited by DC magnetron sputtering. As a sputtering target, ZnO (Zn:O=1:1) with 3% of aluminum added thereto was used. With the input power being set at 1 kW, the ZnO:Al was deposited in an Argon (Ar) gas atmosphere. The layer thickness thereof was 150 nm. The deposition temperature was set at room temperature (without carrying out heating of the substrate in a forced manner).

A current-voltage (I-V) characteristic as an electricity-generating property of the thin-film solar battery of Comparative Example 3 is shown in FIG. 22. For evaluation of the I-V characteristic, a solar simulator with an artificial sunlight source with an intensity of 100 mW/cm² and an AM (air mass) of 1.5 was used. While a bias voltage in the range of ―0.1 V to + 0.5 V was being applied to the side of the Mo electrode as the first electrode 102, measurement was carried out with the side of the ZnO:Al electrode as the second electrode 105 being earthed. An I-V curve in a light irradiation state is shown in FIG. 22. Such an electricity-generating property was obtained that an electric current flowed by light irradiation even when there was no bias (0V). However, it was found that, in comparison with the result concerning Example 17 where AgInTe was used for the p-type layer, the current density and the voltage were very small.

Thus, regarding the thin-film solar battery wherein InS as an n-type semiconductor material different from the II-III(In)-VI(S) compound thin film was used for the n-type layer 104, a change in the I-V curve caused by light irradiation and an electricity-generating property were confirmed, but it was found that the structure given by the present invention could yield a superior property.

According to the present invention, in the thin-film solar battery formed by laying the first electrode 102, the photoelectric conversion layer 100 and the second electrode 105 over the support substrate 101, the photoelectric conversion layer 100 has a laminated layer structure which includes at least the p-type layer 103 and the n-type layer 104, and the n-type layer 104 is a II-III(In)-VI(S) compound thin film which contains at least indium (In), sulfur (S) and element(s) (denoted by the sign II) of at least one group selected from Groups 2, 7 and 12. This structure has made it possible to obtain a thin-film solar battery using a compound semiconductor film, which secures a favorable balance between high energy efficiency and high throughput.

Also according to the present invention, the crystalline state of the II-III(In)-VI(S) compound thin film as the n-type layer 104 is an amorphous state. As described above, the II-III(In)-VI(S) compound thin film as the n-type layer 104 yields a photoelectric conversion property and has high mobility even with a low-temperature process such as post-annealing at 300°C, and the thin film therefore exhibits a property suitable for a photoelectric conversion layer of a solar battery. As demonstrated in Example 16, the II-III(In)-VI(S) compound thin film had large crystal grains in the case of a high-temperature process such as post-annealing at 400°C to 500°C, whereas the II-III(In)-VI(S) compound thin film was in an amorphous state in the case of a low-temperature process such as post-annealing at 300°C. Thus, the II-III(In)-VI(S) compound thin film that is in an amorphous state due to a low-temperature process can be used as a favorable n-type photoelectric conversion layer. Further, the low-temperature annealing enables a low-cost plastic substrate to be utilized as the support substrate, which leads to reduction in costs. Also, there are merits including the fact that the occurrence of crack formation and film peeling, caused by residual stress relaxation related to high-temperature annealing, can be reduced.

Also according to the present invention, the II-III(In)-VI(S) compound thin film as the n-type layer 104 is formed by sputtering. Sputtering is simpler than vacuum vapor deposition, a selenization method and a CBD method that are widely used for producing compound semiconductor films. Thus, the production of the thin film by sputtering has made it possible to achieve even higher throughput. Also, it has been found that since an apparatus for sputtering is simple and uniform thin films can be produced with large areas, reduction in production costs can be achieved.

## Claims

1. A thin-film solar battery comprising:
a substrate;
a first electrode;
a photoelectric conversion layer; and
a second electrode,
the first electrode, the photoelectric conversion layer and the second electrode being placed over the substrate,
wherein the photoelectric conversion layer has a laminated layer structure which includes at least a p-type layer and an n-type layer, and
wherein the n-type layer is formed of a compound containing elements of Group 13, Group 16 and at least one of Groups 2, 7 and 12, the Group 13 includes at least indium, and the Group 16 includes at least sulfur.

2. The thin-film solar battery according to claim 1, wherein the at least one of the Groups 2, 7 and 12 includes at least one element selected from magnesium, calcium, strontium, barium, zinc, cadmium and manganese, the Group 13 includes indium and at least one element selected from gallium, aluminum and boron, and the Group 16 includes sulfur and at least one element selected from tellurium, selenium and oxygen.

3. The thin-film solar battery according to claim 1 or 2, wherein the n-type layer contains zinc, indium and sulfur.

4. The thin-film solar battery according to claim 1 or 2, wherein the n-type layer contains zinc, strontium, indium and sulfur.

5. The thin-film solar battery according to claim 1 or 2, wherein the n-type layer contains zinc, indium, sulfur and oxygen.

6. The thin-film solar battery according to any one of claims 1 to 5, wherein the n-type layer is in an amorphous state as a structural state.

7. A method for producing a thin-film solar battery, comprising:
producing the thin-film solar battery according to any one of claims 1 to 6,
wherein the n-type layer is formed by sputtering.
